# EUROPÄISCHE PATENTSCHRIFT

(11) **EP 1 210 759 B1**
(45) Veröffentlichungstag und Bekanntmachung des Hinweises auf die Patenterteilung: **01.07.2009**
(21) Anmeldenummer: 00953124.5
(22) Anmeldetag: 31.07.2000
(51) Int. Cl.: H02N 2/00, H01L 41/09

(54) **PIEZOELEKTRISCHER ANTRIEB MIT ANREGUNG DURCH LONGITUDINAL- UND BIEGEWELLEN**
PIEZOELECTRIC DRIVE EXCITED BY LONGITUDINAL AND FLEXURAL WAVES
COMMANDE PIEZO-ELECTRIQUE AVEC EXCITATION PRODUITE PAR DES ONDES LONGITUDINALES ET DE FLEXION

(30) Priorität: 17.08.1999 DE 19938954
(43) Veröffentlichungstag der Anmeldung: 05.06.2002
(73) Patentinhaber: Pi Ceramic GmbH Keramische Technologien und Bauelemente, 07589 Lederhose (DE)
(72) Erfinder: WISCHNEWSKIY, Wladimir, D-07589 Münchenbernsdorf (DE)
(74) Vertreter: Kruspig, Volkmar
(86) Internationale Anmeldenummer: PCT/EP2000/007385
(87) Internationale Veröffentlichungsnummer: WO 2001/013505

(56) Entgegenhaltungen:
- EP-A- 0 725 476
- EP-A- 0 878 853
- PATENT ABSTRACTS OF JAPAN vol. 014, no. 200 (E-0920), 24. April 1990 (1990-04-24) & JP 02 041673 A (HONDA ELECTRONIC CO LTD), 9. Februar 1990 (1990-02-09) -& JP 02 041673 A (HONDA ELECTRONIC CO LTD) 9. Februar 1990 (1990-02-09)
- PATENT ABSTRACTS OF JAPAN vol. 014, no. 222 (E-0926), 10. Mai 1990 (1990-05-10) & JP 02 055585 A (RION CO LTD), 23. Februar 1990 (1990-02-23) -& JP 02 055585 A (RION CO LTD) 23. Februar 1990 (1990-02-23)

## Beschreibung

Die Erfindung betrifft einen piezoelektrischen Antrieb, insbesondere zur Erzeugung von Rotations- oder Translationsbewegungen, wobei diese stetig oder schrittweise erfolgen können, gemäß Oberbegriff des Anspruchs 1.

Der erfindungsgemäße Motor kann in Automatisierungssystemen, in der Robotertechnik, als Antrieb für Mikroskoptische, zur Feinpositionierung verschiedener Arten von Koordinatentischen, in optischen und Lasersystemen sowie in vielen anderen Geräten eingesetzt werden, in denen Translationsbewegungen mit hoher Präzisionsgenauigkeit notwendig sind.

Es sind piezoelektrische Motoren oder Antriebe, die auf der Benutzung von akustischen Wanderwellen beruhen, seit längerer zeit bekannt, wobei hier beispielsweise auf die EP 0 475 752 und das US-Patent 5,596,241 verwiesen werden soll.
Derartige Motoren haben jedoch den Nachteil, daß es nicht möglich ist, sie als Miniaturantriebe herzustellen, weil die Mindestlänge des Wellenleiters dieser Motoren ein Vielfaches von 6λ bis 10λ betragen muß. Außerdem ist die Fertigung zu kompliziert und teuer.

Bekannt sind auch lineare piezoelektrische Motoren, welche stehende akustische Wellen benutzen, z.B. nach US-Patent 5,453,653.

Derartige Motoren sind relativ klein und einfach herzustellen. Als Antriebselement in solchen Motoren dient ein monolithischer plattenförmiger piezoelektrischer Oszillator mit einer langen und einer kurzen Seite und mit einem Friktionselement, das an einer seiner kleinen Oberflächen angeordnet ist.
Auf einer der großen Oberflächen enthält der piezoelektrische Oszillator eine erste und eine zweite Elektrodengruppe. Auf der zweiten der Oszillatoroberflächen ist eine ununterbrochene Elektrode angeordnet. Jede der ersten und der zweiten Elektrodengruppen stellt zwei gleich große diagonal angeordnete rechteckige Bereiche der metallisierten Piezokeramikoberfläche dar. Die Quelle der elektrischen Erregung von akustischen Schwingungen leitet die elektrische Spannung zu der ununterbrochenen Elektrode und zur ersten oder zur zweiten Elektrodengruppe.
Aufgrund der asymmetrischen Ausführung jeder der Elektrodengruppen bezüglich der Längsachse des Oszillators erzeugt die elektrische Quellspannung in der Oszillatorplatte eine asymmetrische Verformung. Dies führt dazu, daß das Friktionselement eine Bewegung auf einer geschlossenen Bahn ausführt. Je nachdem an welche Elektrodengruppe die elektrische Spannung angelegt wird, bewegt sich das Friktionselement nach vorn oder in die entgegengesetzte Richtung. Das sich bewegende Friktionselement setzt das angepreßte Element in Bewegung. Die Arbeitsfrequenz des Motors liegt in der Nähe der Resonanzfrequenz der zweiten Schwingungsmode der Biegeschwingungen des Oszillators längs der Oszillatorlänge.

Nachteilig bei derartigen Motoren ist es, daß zur Erzeugung von akustischen Schwingungen eine asymmetrische Verformung der Oszillatorplatte notwendig ist. Ein solcher Motor weist stark unterschiedliche Bewegungsbahnen von an der Funktionsfläche des Oszillators sich befindenden Punkten auf. Dies führt dazu, daß die Tangentialkomponenten der Schwingungsgeschwindigkeiten dieser Punkte sich stark voneinander unterscheiden. Letzteres verursacht Instabilität der Bewegungsgeschwindigkeit des getriebenen Elements, die stark von der reellen Kontaktstelle der Oberfläche des getriebenen Elements mit der Funktionsfläche des Friktionselements abhängig ist.
Außerdem verursacht ein starker Unterschied in den Tangentialkomponenten der Schwingungsgeschwindigkeiten einen unterschiedlich starken Verschleiß der Funktionsfläche des Friktionselements. Dies macht den Motorbetrieb bei längerer Anwendung instabil.

Die Ungleichmäßigkeit in der Bewegungsgeschwindigkeit des getriebenen Elements von bekannten Motoren erreicht bei Geschwindigkeiten größer 0,1 m/s etwa 50%. Bei kleinen Bewegungsgeschwindigkeiten, d.h. kleiner als 0,01 m/s, beträgt die Ungenauigkeit 80% und mehr. Eine solche Ungleichmäßigkeit begrenzt den Einsatzbereich der Motoren und erschwert den Aufbau elektronischer Geschwindigkeitsstabilisatoren, insbesondere für den Bereich sehr kleiner Geschwindigkeiten.

Außerdem sind für solche Motoren hohe Erregerspannungen erforderlich.

Die Konstruktion eines Motors gemäß US-Patent 5,453,653 weist nur ein Friktionselement an der Oberfläche des piezoelektrischen Oszillators auf. Dies macht den Oszillator mechanisch instabil, was bei hohen Bewegungsgeschwindigkeiten des getriebenen Elements die Präzision der Positionierung verringert und zu komplizierten Konstruktionen führt.

Außerdem begrenzt die Verwendung nur eines Friktionselements die maximal mögliche, vom Motor mit nur einem piezoelektrischen Oszillator entwickelte Kraft. Für bekannte Motoren beträgt diese Kraft etwa 10 N, was für viele Anwendungen unzureichend ist. Die Verwendung von mehreren, in einem Paket zusammengesetzten Oszillatoren begrenzt wiederum die Positionierungspräzision des getriebenen Elements. Letztendlich sei noch auf die gattungsbildende JP-A-02041673 hingewiesen.

Es ist daher Aufgabe der Erfindung, einen piezoelektrischen Antrieb bzw. Motor anzugeben, der eine gleichmäßige Bewegungsgeschwindigkeit des getriebenen Elements bei hohen und niedrigen Geschwindigkeiten aufweist, der eine höhere Betriebsstabilität über eine längere Motorbetriebszeit besitzt, eine niedrige Erregungsspannung benötigt, eine große Kraft entwickelt, eine stabile Oszillatorkonstruktion besitzt und eine Einrichtung oder Vorrichtung zur Verfolgung der Oszillatorresonanzfrequenz aufweist.

Die Lösung der Aufgabe der Erfindung erfolgt mit einem Gegenstand, wie er im geltenden Hauptanspruch beschrieben ist, wobei die Unteransprüche mindestens zweckmäßige Ausgestaltungen und Weiterbildungen umfassen.

Es stellen die erste und die zweite Elektrodengruppe zwei Bereiche gleicher Konfiguration dar, die sich an den beiden großen gegenüberliegenden metallisierten Oberflächen des plattenförmigen piezoelektrischen Wandlers oder Oszillators (der piezoelektrischen Platte) befinden. Jede der beiden Elektrodengruppen bildet mindestens einen unabhängigen Generator von nicht miteinander verbundenen, akustischen stehenden Wellen, die sich längs der langen Seite des piezoelektrischen Oszillators bzw. der Platte ausbreiten. Die erste Elektrodengruppe bildet einen Längswellengenerator und die zweite einen Biegewellengenerator akustischer Wellen. Die Quelle der elektrischen Erregung von akustischen Schwingungen geht von einem Grundgenerator aus, der elektrisch mit Signaleingängen eines Zweikanal-Leistungsverstärkers verbunden ist. Jeder Ausgang des Zweikanal-Leistungsverstärkers ist elektrisch mit den entsprechenden Elektrodengruppen verbunden.

Da die erste Elektrodengruppe mindestens einen unabhängigen Generator von stehenden akustischen Längswellen bildet und die zweite mindestens einen unabhängigen Generator stehender akustische Biegewellen darstellt und diese so ausgeführt sind, daß zwischen ihnen keine Verbindung existiert, d.h. daß die von den Generatoren erzeugten Wellen keinen Einfluß aufeinander haben, sind die im piezoelektrischen Oszillator sich ausbreitenden Wellen reine Längs- und reine Biegewellen.
Solche Wellen führen zu reinen elliptischen Bewegungsbahnen des Oszillatorkörpers und haben praktisch gleiche Form mit wenig unterschiedlichen Amplituden in den Gebieten der eindeutigen Maxima stehender Biegewellen.
Dies ermöglicht eine Bewegung der Punkte in diesen Gebieten auf den Funktionsflächen der Friktionselemente mit praktisch gleicher Geschwindigkeit. Das Ganze erlaubt daher eine erhebliche Stabilitätserhöhung sowohl bei niedrigen als auch bei hohen Bewegungsgeschwindigkeiten des getriebenen Elements.

Die Konfiguration der Elektrodengruppe ist so ausgeführt, daß die Generatoren von akustischen Längs- und Biegewellen das ganze aktive Volumen der piezoelektrischen Platte ausfüllen. Dies verringert die Erregerspannung in vorteilhafter Weise.

Beim vorgeschlagenen Motor stellt die erste Elektrodengruppe rechteckige Bereiche der metallisierten Oberfläche des plattenförmigen Oszillators dar. Die Höhe ist hier gleich der Breite. Dazwischen befindet sich Normalenrichtung (senkrecht) zu den Elektroden eine einrichtungspolarisierte Piezokeramik. Die Elektroden befinden sich an den Orten von Schwingungsgeschwindigkeitsknoten der stehenden akustischen, sich in dem Oszillator ausbreitenden Längswelle.
Eine solche Elektrodenkonstruktion, die einen Generator von akustischen Längswellen bildet, erlaubt die Erzeugung reiner Längswellen in der Oszillatorplatte.

Die zweite Elektrodengruppe stellt ebenfalls rechteckige Bereiche der metallisierten Oberfläche des plattenförmigen piezoelektrischen Oszillators dar. Die Höhe ist wiederum gleich der Breite. Dazwischen befindet sich in Normalenrichtung (d.h. senkrecht zu den Elektroden) eine einrichtungspolarisierte Piezokeramik. Die Elektroden befinden sich wiederum an den Orten von Schwingungsgeschwindigkeitsmaxima der stehenden akustischen, sich in dem Oszillator ausbreitenden Biegewelle und besitzen isolierende Bereiche oder Abstände entlang ihrer Längsachse.

Eine derartige Elektrodenkonstruktion erlaubt die Erzeugung reiner Biegewellen.

Beim vorgeschlagenen Antrieb stellt die zweite Elektrodengruppe rechteckige Bereiche der metallisierten Oberfläche des plattenförmigen piezoelektrischen Oszillators dar, wobei die Höhe gleich der Breite ist und in Normalenrichtung verschieden gerichtete und symmetrisch bezüglich der Längsachse des Oszillators polarisierter Piezokeramik zwischen diesen Bereichen bzw. an den Orten von Schwingungsgeschwindigkeitsmaxima der stehenden akustischen, sich in dem Oszillator ausbreitenden Biegewellen.

Eine derartige Elektrodenkonstruktion ermöglicht die Ausführung der Generatorelektroden der akustischen Biegewelle ohne isolierende Abstände dazwischen, was deren Effektivität erhöht.

Bei der Lösung des Antriebs sind die Friktionselemente als dünne Streifen aus einem harten, abriebsfesten Stoff, z.b. Oxidkeramik, Metallkeramik oder aus einer Kombination mit anderen Werkstoffen ausgebildet. Die Friktionselemente befinden sich in Gebieten von Schwingungsgeschwindigkeitsmaxima der sich in dem plattenförmigen piezoelektrischen Oszillator bzw. der Oszillatorplatte ausbreitenden akustischen Biegewelle.

Eine solche Ausführungsform führt zu einer Homogenität der Tangentialkomponente der Schwingungsgeschwindigkeit auf der Funktionsfläche.

In einer weiteren Variante des Motors sind die Friktionselemente an einer kleineren unteren Oberfläche des plattenförmigen piezoelektrischen Oszillators angeordnet. Diese Ausführungsvariante des Motors erlaubt das Aufbringen mehrerer Friktionselemente, wodurch die vom Motor erzeugte Kraft bzw. die Kraftübertragung verbessert werden kann. Bei einer ergänzenden Konstruktionsvariante des Motors ist ein Friktionselement an der kleinen Seitenoberfläche des plattenförmigen piezoelektrischen Oszillators angeordnet.
Hierbei wird eine maximal mögliche Geschwindigkeit des getriebenen Elements erreicht.

Die Friktionselemente des Motors können eine Zweischichtstruktur besitzen.
Die erste Schicht dieser Struktur wird aus einem harten, verschleißfesten Werkstoff mit hoher Reibungszahl im Vergleich zur Friktionsschicht des getriebenen Elements gefertigt. Die zweite Schicht besteht aus einem harten, porösen Werkstoff.
Beide Schichten sind durch ein Verschweißen beim Sintern miteinander verbunden. Im Verbindungsbereich der ersten und der zweiten Schicht kann eine dritte sogenannte Übergangsschicht gebildet sein.

Bei dieser Ausführungsvariante des Motors ist eine Kombination der Temperaturkoeffizientenunterschiede der Piezokeramik und des Materials des Friktionselements möglich und es kann eine Erhöhung der Festigkeit der Klebeverbindung des Friktionselements mit der Piezokeramikoberfläche erreicht werden.

Die Friktionselemente können mittels eines speziellen Bindestoffs mit der Oberfläche des Piezooszillators verbunden werden, wobei der Bindestoff sowohl mit der piezoelektrischen Keramik als auch mit dem Material des Friktionselements eine chemische Verbindung eingeht, und zwar mittels eines leichtschmelzenden, bleihaltigen Glases.

Beim vorgeschlagenen Antrieb können die Friktionselemente auch als auf die Oberfläche des plattenförmigen piezoelektrischen Oszillators aufgeschmolzene Glasstreifen gebildet werden. Das Glas ist mit einem Pulver eines harten, verschweißfesten Werkstoffs versetzt, z.B. Aluminiumoxid, Zirkonoxid, Siliziumkarbid, Titankarbid oder ähnlichen Materialien oder ihrer Gemische. Die Streifen sind an den Orten von eindeutigen Maxima der Schwingungsgeschwindigkeiten der akustischen Biegewelle befindlich. Bei dieser Ausführungsvariante wird eine maximal mögliche Reibungszahl in dem Friktionselement und der Friktionsschicht des getriebenen Elements erreicht.

Bei dem beschriebenen Antrieb ist die monolithische Platte mit mindestens einem fixierenden Element versehen, um die Platte mechanisch zu befestigen.

In den unterschiedlichen Ausführungsvarianten können diese Fixationselemente als rechteckige, dreieckige, halbzylindrische Prismen, als konische, pyramidenfrmige, halbsphärische Elemente oder in Form von rechteckigen Elementen mit Profilrillen bzw. als runde Elemente mit Profilbohrungen ausgeführt werden.
Die Elemente befinden sich an den Orten von Schwingungsknoten der stehenden akustischen, sich in dem Oszillator ausbreitenden Längswelle und sind starr mit seiner Oberfläche verbunden. Hierdurch wird eine hohe Positionspräzision erreicht. Die Fixationselemente können aus solchen Werkstoffen gefertigt werden, deren Elastizitätsmodul ungefährt gleich oder ein wenig höher als der Elastizitätsmodul der Piezokeramik des plattenförmigen piezoelektrischen Oszillators ist. Hierdurch wird eine hohe Gesamtfestigkeit erreicht.

Die fixierenden Elemente können auch aus Werkstoffen gefertigt werden, deren Elastizitätsmodul viel kleiner als der Elastizitätsmodul der Piezokeramik ist. Hierbei wird die aus den akustischen Oszillatorschwingungen zwischen den fixierenden Elementen und der Oberfläche des piezoelektrischen Oszillators resultierende Kraft verringert.

In einer Variante des Motors können die fixierenden Elemente und der plattenförmige piezoelektrische Wandler aus demselben Piezokeramiktyp gefertigt werden.

Auch besteht die Möglichkeit, die Fixationselemente oder Teile von diesen aus poröser Oxidkeramik oder einem anderen porösen Material zu fertigen, wodurch eine gute Klebeverbindung des Fixationselements mit der Oberfläche der piezoelektrischn Platte erreichbar ist.

Bei dem beanspruchten Antrieb können die fixierenden Elemente auch als biegende Resonanzplatten ausgeführt sein. In dieser Ausführung wird die in das Resonanzsystem der piezoelektrischen Platte von den fixierenden Elementen hineingebrachte Dämpfung minimal, wodurch die Energieverluste in dem piezoelektrischen Oszillator verringerbar sind.

Die fixierenden Elemente können mittels organischem Kleber mit der Piezokeramikoberfläche verbunden werden. Hierdurch können Werkstoffe unterschiedlicher Temperaturkoeffizienten eingesetzt werden.

Bei einer weiteren Ausführungsform des Antriebs wird die Friktionsschicht des getriebenen Elements in Form einer Keramikoxidschicht ausgeführt mit einer Dicke, die mindestens fünfmal kleiner als die halbe Wellenlänge der sich im Oszillator ausbreitenden akustischen stehenden Längswelle ist. Hierdurch können unerwünschte Schwingungen unterdrückt werden.

Bei einer weiteren Variante ist die Körperdicke des sich unter der Friktionsschicht befindlichen getriebenen Elements größer als die halbe Wellenlänge der sich im Oszillators ausbreitenden stehenden akustischen Biegewelle. In diesem Fall wird die Entstehung einer akustischen Biegewelle im Körper des getriebenen Elements nahezu völlig ausgeschlossen.

Ebenso ist es möglich, zwischen dem Körper des getriebenen Elements und seiner Friktionsschicht eine Dämpfungsschicht anzuordnen, die aus organischen Werkstoffen oder harten porösen Werkstoffen bzw. Kombinationen derartiger Stoffe gefertigt ist. Hierdurch wird die akustische Kopplung verringert und eine thermische Inkompatibilität aufgrund unterschiedlicher Ausdehnungskoeffizienten der Friktionsschicht und des getriebenen Elements beseitigt.

Das getriebene Element kann erfindungsgemäß in Form eines rechteckigen, vieleckigen oder runden Querschnitt aufweisenden Balkens ausgeführt sein. Es kann jedoch auch als Rohr ausgebildet sein.

Das getriebene Element kann auch in Form eines aus einem harten Material und einen rechteckigen Querschnitt aufweisenden Balken gebildet werden, in dessen Körper in periodischen Abständen Dämpfungsnuten eingebracht sind.

Wenn das getriebene Element aus einem harten porösen Werkstoff gefertigt ist, werden die im Körper dieses Elements entstehenden Längswellen in vorteilhafter Weise gedämpft. Ebenso können die Poren des getriebenen Elements mit einem schalldämpfenden Füllstoff ausgefüllt werden, so daß eine Dämpfung der Längs- als auch der Biegewellen erfolgt.

Eine weitere konstruktive Variante des Motors schließt mindestens zwei gegenüberstehende und in einer Ebene liegende plattenförmige piezoelektrische Oszillatoren oder Wandler ein, wobei diese mindestens zwei Friktionsschichten besitzen, die zueinander parallel stehen und die sich an den zwei gegenüberliegenden Seiten befinden. Hierbei ist ein Verzicht auf Stützlager möglich.

Auch ist der Einsatz mindestens dreier plattenförmiger Wandler oder mindestens drei Friktionsschichten, die parallel zueinander stehen und in mindestens drei Ebenen liegen, denkbar. Hierbei ist das getriebene Element sehr stabil in der zu seiner Längsachse senkrecht stehenden Ebene.

Bei einer Ausführungsform des Motors ist das getriebene Element als Rotationskörper ausgeführt. Denkbar ist auch, die fixierenden Element des piezoelektrischen Wandlers in einem festen Träger anzuordnen.

Eine andere Variante in konstruktiver Hinsicht besteht darin, die fixierenden Elemente des plattenförmigen piezoelektrischen Oszillators oder Wandlers in einem flachen federartigen Träger anzuordnen oder aufzustellen, wodurch Querverschiebungen des getriebenen Elements kompensiert werden können und damit eine Erhöhung der Gleichmäßigkeit der Bewegung gegeben ist.

Ansteuerungsseitig ist der Ausgang eines Grundgenerators mit einem der Signaleingänge eines Zweikanal-Leistungsverstärkers über einen Phasenschieber verbunden. Hierdurch kann die Form der Bewegungsbahnen von Punkten der Arbeitsoberflche des Friktionselemente optimal eingestellt werden.

Bei einer weiteren schaltungstechnischen Variante ist jeder Kanal des Zweikanal-Leistungsverstärkers als ein Brückenleistungsverstärker mit zwei Halbbrückenverstärkern und zwei Phasensteuerer enthaltenden Erregerkanälen ausgebildet. Hierdurch kann eine elektronische Steuerung der Bewegungsgeschwindigkeit des getriebenen Element erfolgen.

Ergänzend ist es möglich, einen Signalpegelwandler und einen Nullsignaldetektor bezüglich des Steuersignals vorzusehen, um den Motor mit einer unipolaren Spannung anzusteuern.

Der piezoelektrische Wandler, d.h. der plattenförmigen Oszillator kann mit einem Sensor zur Erfassung der Längskomponente von mechanischen Spannungen versehen sein. Dieser Sensor befindet sich in einem der Geschwindigkeitsknoten der sich im plattenförmigen piezoelektrischen Oszillator ausbreitenden Längswelle. Hierdurch können Längsspannungen bestimmt und damit die Schwingungsgeschwindigkeit der sich im Oszillator ausbreitenden Längswelle ermittelt werden.

Weiterhin kann der plattenförmige piezoelektrische Wandler mit einem Sensor zur Ermittlung der Biegekomponente der mechanischen Spannungen versehen sein. Dieser Sensor befindet sich in einem der Schwingungsgeschwindigkeitsmaxima der Biegewelle, die sich im Wandler ausbreitet.

Der Generator, d.h. die Quelle der elektrischen Erregung von akustischen Schwingungen kann mit einem Phasendetektor zur Ermittlung des vom Sensor der Komponenten von mechanischen Spannungen herrührenden Signals ausgestattet sein. Der Phasendetektor enthält Stütz- und Phasenmeßeingänge und einen Ausgang, wobei der Grundgenerator einen Eingang zur elektrischen Frequenzsteuerung besitzt. Der Stützeingang des Phasendetektors ist elektrisch mit einer der Elektrodengruppen verbunden. Der Meßeingang des Phasendetektors ist elektrisch am Sensor zur Ermittelung der mechanischen Spannungen angeschlossen. Der Ausgang des Phasendetektors ist elektrisch mit dem Eingang zur elektrischen Steuerung der Erregungsfrequenz des Grundgenerators verbunden. Bei einer solchen Schaltungsanordnung kann eine genaue Verfolgung der mechanischen Resonanzfrequenz einer der Schwingungstypen des piezoelektrischen Wandlers vorgenommen werden, um den Motorbetrieb weiter zu stabilisieren.

Die Erfindung soll nachstehend anhand von Ausführungsbeispielen sowie unter Zuhilfenahme von Figuren näher erläutert werden.

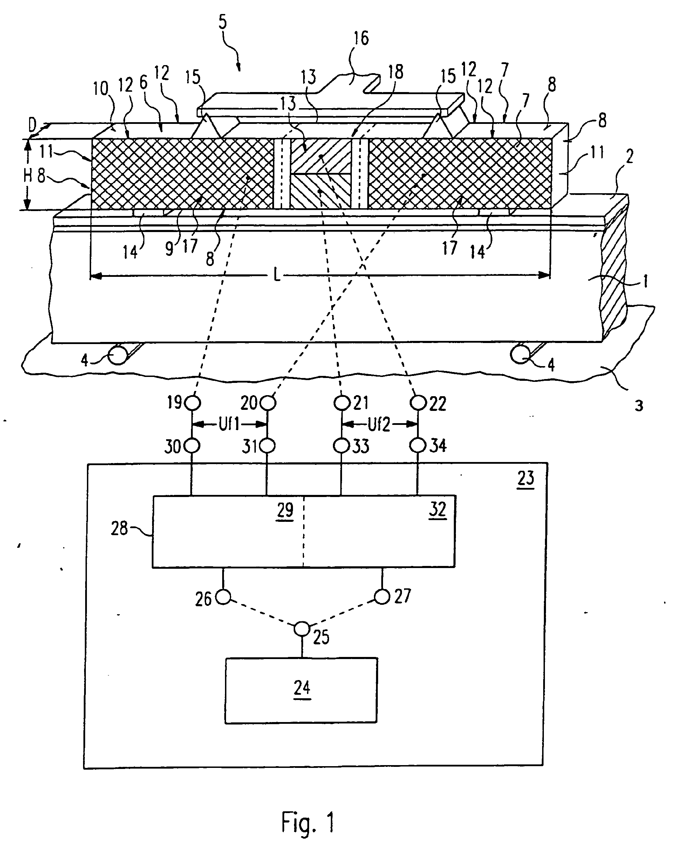

Die Fig. 1 zeigt hierbei eine allgemeine Darstellung des Antriebs mit einem 2/5 Modenoszillator.

Der Antrieb enthält das getriebene Element 1 mit der dort befindlichen Friktionsschicht 2 und das treibende Element 5. Das getriebene Element 1 ist auf einem Gehäuse 3 und Lagern 4 angeordnet.

Das treibende Element 5 besteht aus einem monolithischen, plattenförmigen piezoelektrischen Oszillator oder Wandler 6 der Stärke D und der Länge L. D und L sind ungleich der Breite H.

Das treibende Element 5 enthält zwei große Oberflächen 7 und vier kleine Oberflächen 8, die aus kleinen unteren Oberflächen 9, kleinen oberen Oberflächen 10 und zwei kleinen Seitenoberflächen 11 bestehen.

Auf den großen Oberflächen 7 befinden sich erste 12 und zweite 13 Elektrodengruppen. Auf der unteren Oberfläche 9 sind beim gezeigten Beispiel zwei Friktionselemente 14 angeordnet. Auf der oberen Oberfläche 10 sind zwei fixierende Elemente 15 befindlich.

Die Friktionselemente 14 stehen im elastischen Friktionskontakt mit der Friktionsschicht 2 des getriebenen Elements 1.

Die Elemente 15 sind mit einer Anpreßvorrichtung 16 bezüglich des Gehäuses 3 fixiert.

Die erste Elektrodengruppe 12 bildet zwei gleichphasige Generatoren von stehenden akustischen, längs der Länge L des piezoelektrischen Oszillators 6 sich ausbreitenden Längswellen 17.
Die zweite Elektrodengruppe 13 bildet einen Generator von stehenden akustischen, längs der Länge L des piezoelektrischen Oszillators sich ausbreitenden Biegewellen 18.

In Fig. 1 und in weiteren Figuren sind die Generatoren 17 und 18 mit einer gestrichelten Linie voneinander abgegrenzt. Jede der Elektrodengruppen 12 und 13 besitzen elektrische Anschlüsse 19, 20 bzw. 21, 22.

Schaltungstechnisch ist eine Quelle zur Erzeugung von Schwingungen 23 und ein Grundgenerator 24 vorgesehen. Der Ausgang 25 des Grundgenerators 24 ist elektrisch mit den Signaleingängen 26 und 27 eines Zweikanal-Leistungsverstärkers 28 verbunden. Der erste Kanal 29 des Leistungsverstärkers 28 besitzt einen nichtinvertierenden Ausgang 30 und einen invertierenden Ausgang 31. Der zweite Kanal des Leistungsverstärkers 28 weist den nichtinvertierenden Ausgang 33 und den invertierenden Ausgang 34 auf.

Der erste Kanal 29 erzeugt an seinen Ausgängen 30 und 31 die Spannung Uf1. Der zweite Kanal 32 erzeugt an seinen Ausgängen 33 und 34 die Spannung Uf2.

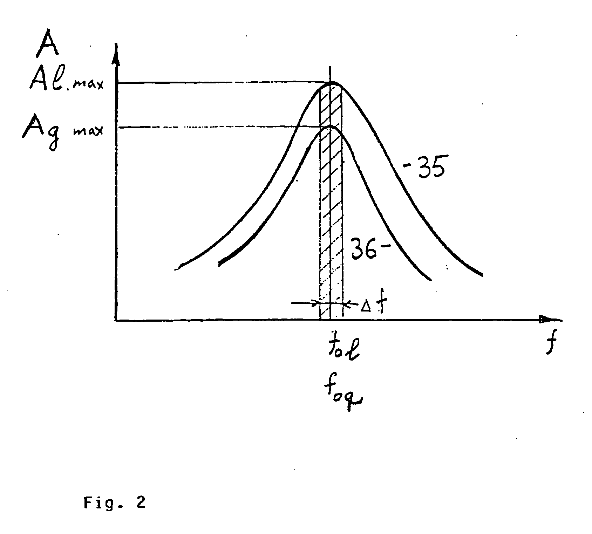

Fig. 2 stellt die Lage der Resonanzkurven des plattenförmigen Wandlers 6 auf der Frequenzskala f dar. Dabei bedeuten:
- A: Verformungsamplitude des Oszillators;
- Almax: maximale Amplitude der Längsverformungen;
- Agmax: maximale Amplitude der Biegeverformungen;
- f01 und f0q: Resonanzfrequenzen der Längs- und Biegeschwingungen;
- Δf: Frequenzband, welches der zulässigen Differenz von Resonanzfrequenzen des Oszillators 6 entspricht;
- Kurve 35: Resonanzcharakteristik von Längsschwingungen des Oszillators 6;
- Kurve 36: Resonanzcharakteristik von Biegeschwingungen des Oszillators 6.

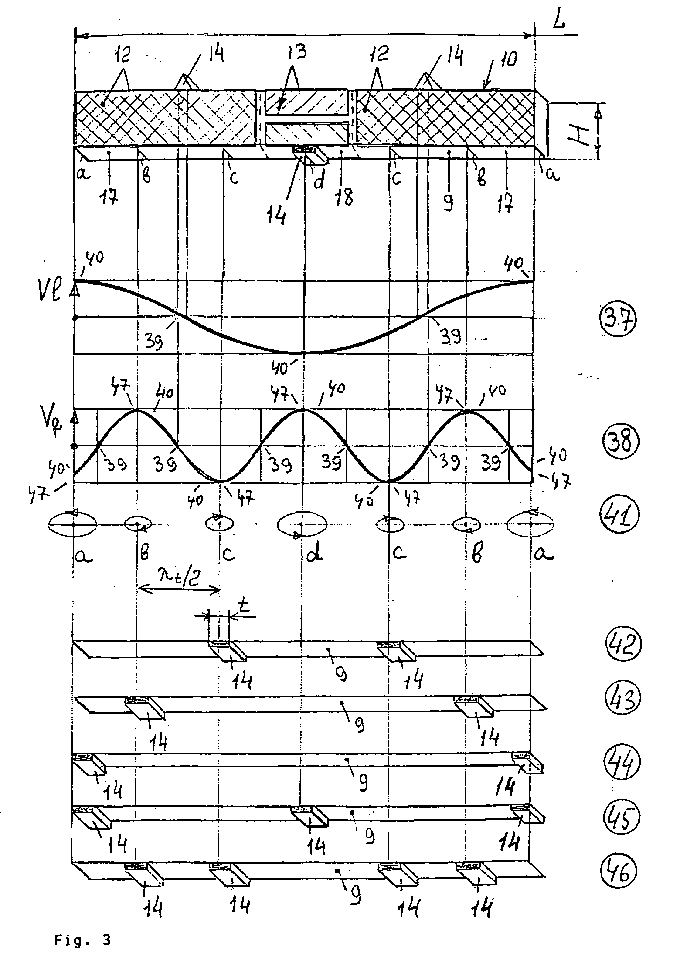

Die Fig. 3 stellt einen Piezowandler nach Art eines 2/5 Modenoszillators dar und enthält Diagramme der Verteilung von Schwingungsgeschwindigkeiten V1 (Position 37) und Vg (Position 38) längs seiner Länge L auf der oberen 9 und der unteren 10 Oszillatoroberflächen. Die Diagramme der Verteilung von Schwingungsgeschwindigkeiten 37 und 38 enthalten auch die Schwingungsgeschwindigkeitsknoten 39 und die Schwingungsgeschwindigkeitbäuche oder -maxima 40.
Auf der Position 41 der Fig. 3 sind die Bewegungsbahnen von Punkten dargestellt, die entlang der Linie a, b, c, d liegen. Diese ensprechen Schwingungsgeschwindigkeitsmaxima der in dem Oszillator 6 entstehenden Biegewelle.
Auf der Position 42, 43, 44, 45, 46 sind die möglichen Lagen der sich auf der unteren Oberfläche 9 befindlichen Friktionselemente 14 gezeigt. Die Friktionselemente befinden sich in den Bereichen der eindeutigen Maxima 47 von Schwingungsgeschwindigkeiten der sich in dem Oszillator 6 ausbreitenden stehenden akustischen Biegewelle.
Dort haben die elliptischen Bewegungsbahnen der Punkte die gleiche Drehrichtung. Auf der oberen Oszillatorfläche 10 sind zwei fixierende Elemente 15 befestigt, die sich in den Gebieten von Knoten 14 der stehenden akustischen Längswelle befinden.

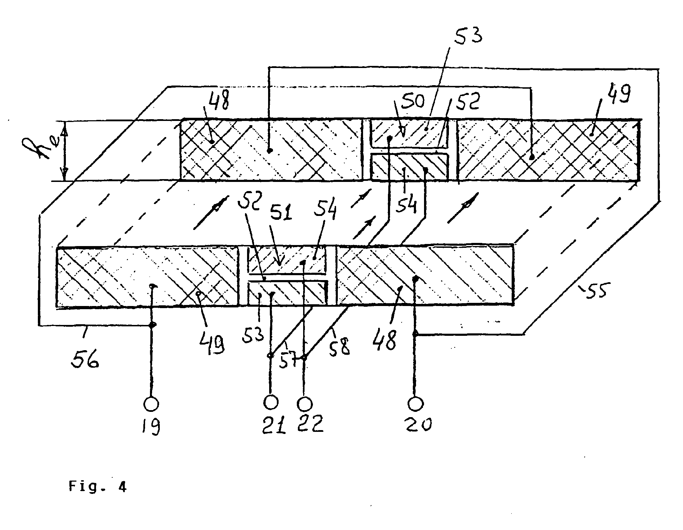

Die Fig. 4 bis 8 stellen mögliche Konfigurationen der ersten 12 und der zweiten 13 der Elektrodengruppen dar. Außerdem zeigen die Fig. 4 bis 8 die Schemata von elektrischen Verbindungen der Elektroden innerhalb von jeder Elektrodengruppe als auch die Polarisationsrichtung der Piezokeramik zwischen den Elektroden für einen 2/5 Modenoszillator 6.

Die in Fig. 4 dargestellte Konfiguration der Elektrodengruppen 12 wird von den Elektroden 48 und 49 gebildet, wobei die zweite Elektrodengruppe 10 die Elektroden 50 und 51 besitzt.

Die Höhe he der Elektroden 48,49 und 50, 51 ist ungefähr gleich der Breite H des plattenförmigen piezoelektrischen Wandlers 6.

Die Elektroden 50 und 51 der zweiten Elektrodengruppe 13 enthalten die isolierenden Zwischenbereiche 52. Diese sind entlang der Längsachse des Oszillators 6 angeordnet und teilen die Elektroden in zwei gleiche Teile 53 und 54.
Bei dieser Variante der Elektrodenkonfiguration ist die piezoelektrische Keramik des Oszillators 6 homogen senkrecht zur Elektrode (in Normalenrichtung) polarisiert.
In Fig. 4 ist die Polarisation mit Pfeilen symbolisiert. Die Elektroden 48, 49 und 50, 51 sowie ihre Teile 53 und 54 sind mit Hilfe der Leiter 55, 56 und 57, 58 verbunden.

Der Oszillator 6 mit den in Fig. 4 dargestellten Konfigurationen von Elektrodengruppen und mit deren Verbindungsschemata weist zwei Längswellengeneratoren 17 und einen Biegewellengenerator 18 auf. Der Längswellengenerator 17 wird durch die Elektroden 48 und 49 der ersten Elektrodengruppe 12 und der Biegewellengenerator 18 durch die Elektroden 50, 51 der zweiten Elektrodengruppe 13 gebildet.
Die Elektroden 48, 49 und die dadurch gebildeten Generatoren sind so angeordnet, daß diese sich in den Gebieten der Schwingungsgeschwindigkeitsknoten 39 der sich ausbildenden stehenden akustischen, sich in dem Oszillator 6 ausbreitenden Längswelle befinden (siehe Fig. 3).

Die Elektroden 50, 51 und damit die Generatoren 18 sind so angeordnet, daß diese sich in den Gebieten der Schwingungsgeschwindigkeitsmaxima 40 von stehenden akustischen, sich in dem Oszillator 6 ausbreitenden Biegewellen befinden (hierzu ebenfalls siehe Fig. 3).

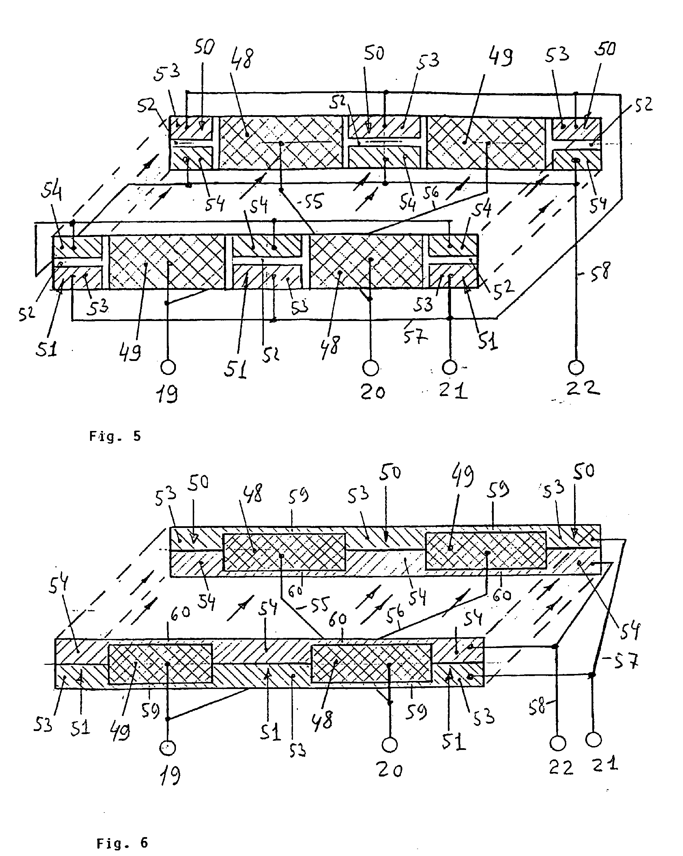

Der Oszillator 6 mit der in Fig. 5 dargestellten Konfiguration von Elektrodengruppen besitzt zwei Längswellengeneratoren 17 und drei Biegewellengeneratoren 18.

Die Generatoren 17 werden durch die gegenüberliegenden Elektroden 48, 49 und die Generatoren 18 durch die gegenüberliegenden Elektroden 50, 51 gebildet.
Der Oszillator 6 muß eine eindeutige Einrichtungspolarisation der zwischen den Elektroden liegenden Piezokeramik haben, so wie es in Fig. 5 mit Pfeilen symbolisiert ist.

Bei der in Fig. 6 dargestellten Konfiguration von Elektrodengruppen sind im Unterschied zur Lösung nach Fig. 5 Teile der die Elektroden 53 und 54 verbindenden Leitungen auf der Oberfläche des Oszillators 6 in Form von dünnen, stromleitenden Streifen 59, 60 ausgebildet.

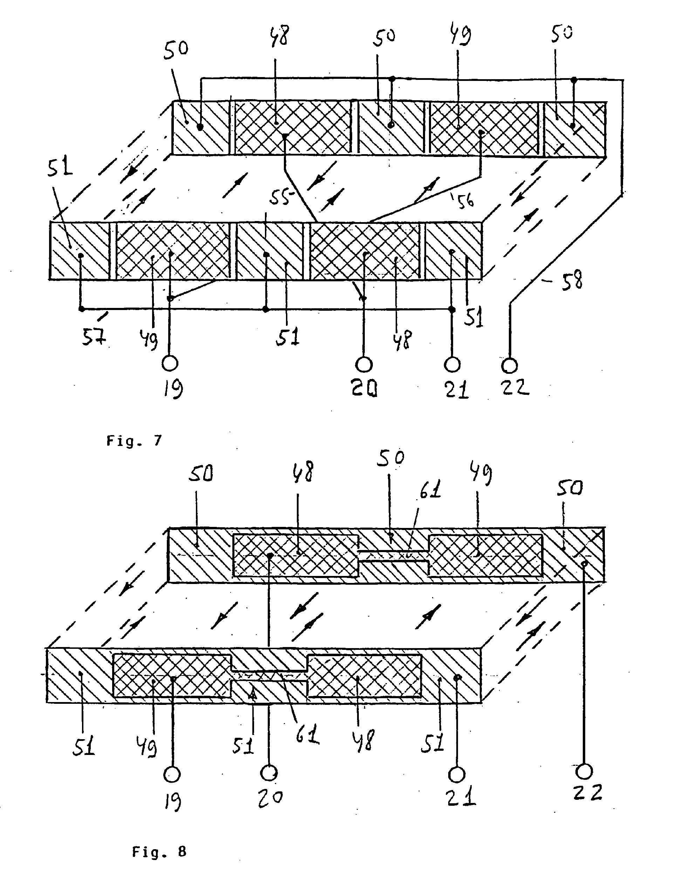

Die in Fig. 7 darstellte Variante einer Elektrodengruppenkonfiguration besitzt eine in verschiedene Richtung realisierte Polarisation der zwischen den Elektroden 50 und 51 der zweiten Elektrodengruppe 13 liegenden Piezokeramik. Die Piezokeramik wird hier in Normalenrichtung zur Elektrodenoberfläche 50, 51 und in entgegengesetzter Richtung bezüglich der Längsachse des Oszillators 6 polarisiert, wie es im einzelnen in Fig. 7 dargestellt ist.

Bei der in Fig. 8 dargestellten Variante der Elektrodengruppenkonfiguration ist in jedem der zwei Grundgeneratoren 17 zur Erzeugung von akustischen Längswellen zusätzlich eine in verschiedener Richtung polarisierte Piezokeramik vorgesehen, die zwischen den Elektroden 48 und 49 der ersten Elektrodengruppe 12 liegt. Dies ermöglicht es, die auf jeder der großen Oszillatoroberfläche liegenden Elektroden 48 und 49 mit Hilfe von stromleitenden Streifen 61 zu verbinden.

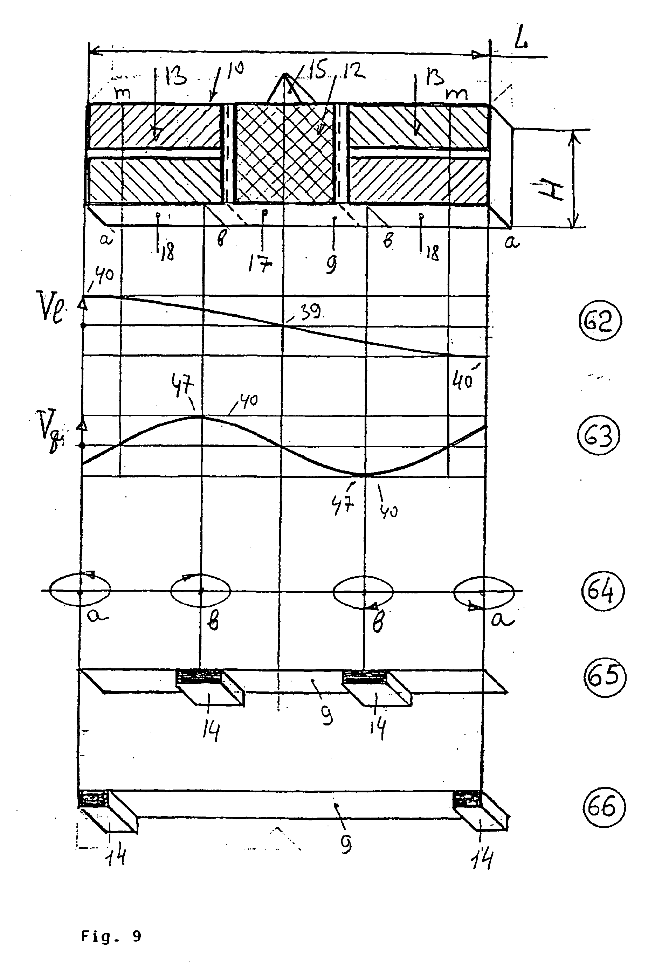

Fig. 9 zeigt einen 1/2-Modenoszillator 6 vom Längstyp. Dieser hat einen Längswellengenerator 17 und zwei Biegewellengeneratoren 18. Beide Generatoren sind im Bild mit den dort erkennbaren gestrichelten Linien voneinander abgegrenzt.

Die Positionen 62 und 63 zeigen Diagramme der Verteilung von Schwingungsgeschwindigkeiten V1, Vg längs der Oszillatorlänge L und entlang der unteren 9 und der oberen 10 der Oszillatoroberflächen. In der Position 64 sind die Bewegungsbahnen von Punkten dargestellt, die längs der Linien a und b liegen. Diese Linien entsprechen den Maxima 47 von Schwingungsgeschwindigkeiten der sich im Oszillator 6 ausbreitenden Biegewelle.
Die Positionen 65 und 66 zeigen mögliche Lagen der Friktionselemente 14 auf der unteren Oberfläche 9 des Oszillators 6. Das fixierende Element 15 ist bei dieser Ausführungsvariante im Zentrum der oberen Oberfläche 10 des Oszillators 6 befindlich. Dort bilden sich auch die Knoten 39 von Längs- und Biegewelle aus. Bei dieser Ausführungsvariante ist es auch möglich, die fixierenden Elemente 15 an den Orten zweier äußerer Knoten der Biegewelle, d.h. längs der Linie m anzuordnen. In diesem Fall müssen aber die fixierenden Elemente eine Bewegungsfreiheit in Längsrichtung haben

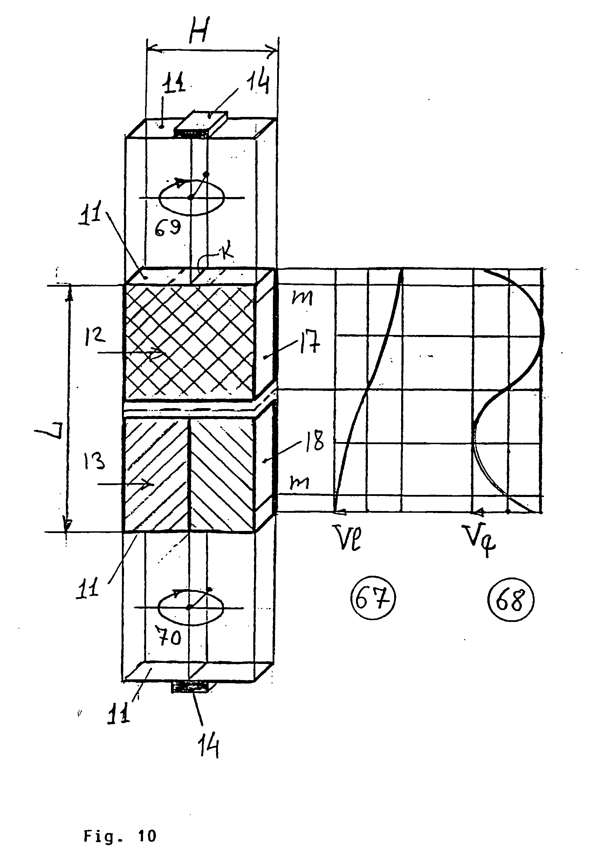

Fig. 10 zeigt einen plattenförmigen 1/2-Modenoszillator 6 vom Quertyp. Dieser enthält einen Längswellengenerator 17 und einen Biegewellengenerator 18. Die Positionen 67 und 68 sind Diagramme der Verteilung von Schwingungsgeschwindigkeiten Vl und Vg längs der Oszillatorlänge L. Die Positionen 67 und 68 stellen ebenfalls die Bewegungsbahnen von Punkten auf der Mittellinie k der Seitenoberflächen 11 des Oszillators 6 dar. Der in Fig. 10 dargestellte Oszillator vom Quertyp unterscheidet sich von dem 1/2-Modenoszillator vom Längstyp dadurch, daß das Friktionselement 14 auf einer seiner Seitenoberflächen 11 befestigt wird. Die fixierenden Elemente 15 in einer solchen Ausführungsvariante des Oszillators 6 sind entweder im Zentrum der unteren 9 und oberen 10 der Oszillatoroberflächen angeordnet oder auf den Oberflächen längs der Linien M in den Bereichen von zwei äußeren Knoten der stehenden akustischen Biegewelle.

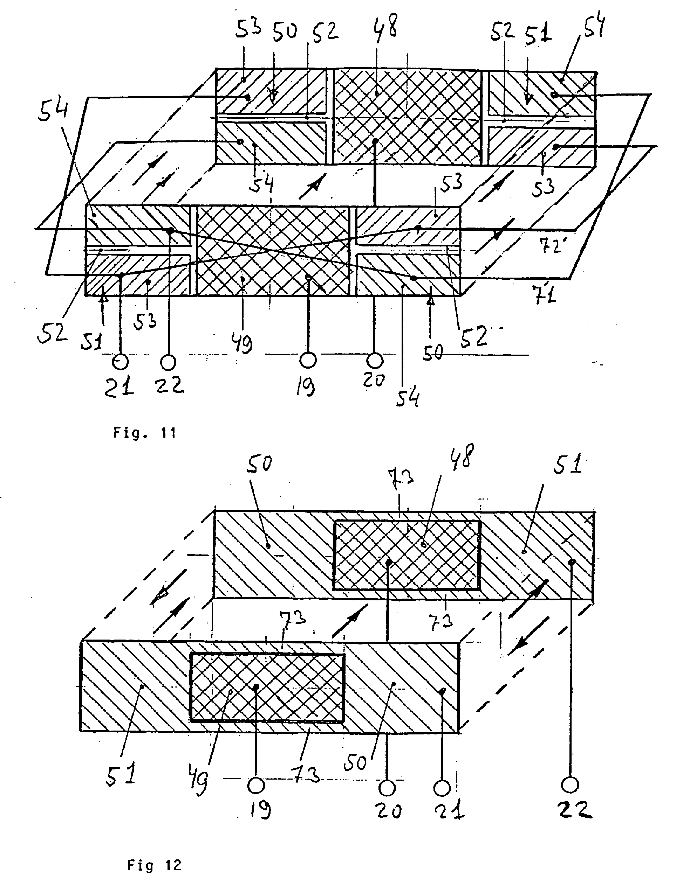

Die Fig. 11 bis 15 stellen Konfigurationensvarianten von Elektrodengruppen und Polarisationsrichtungen des 1/2-Modenoszillators dar. Derartige Ausführungsvarianten können sowohl für Oszillatoren vom Längs- als auch für solche vom Quertyp Verwendung finden.

Der Oszillator gemäß Fig. 11 besitzt zwei Biegewellengeneratoren 18 und einen Längswellengenerator 17 (siehe auch Fig. 9). Diese Generatoren werden durch die zwei Elektrodengruppen 12, 13 gebildet. Sie schließen ebenfalls die Elektroden 50, 51 und 48, 49 ein. Die Elektroden 50, 51 sind durch isolierende Zwischenbereiche 52 in zwei Teile 53, 54 geteilt. Die gleichrangigen Teile 54, 54 der Elektroden 50, 51 sind mittels Leiter 71, 72 unteeinander verbunden. Der Oszillator 6 mit der in Fig. 11 dargestellten Elektrodengruppenkonfiguration besitzt eine in Normalenrichtung zur den Elektroden vorhandenen Einrichtungspolarisation der Piezokeramik, wie es mit den Pfeilen symbolisiert ist.

Der Oszillator mit der gemäß Fig. 12 gezeigten Elektrodengruppenkonfiguration besitzt ebenfalls zwei Biegewellengeneratoren 18 und einen Längswellengenerator 17, so wie es auch in den Fig. 9 und 11 dargestellt ist. Die Generatoren 18, 17 werden durch die Elektroden 50, 51 und 48, 49 gebildet. Die auf einer Seite des Oszillators 6 angeordneten Elektroden 50 und 51 sind durch dünne stromleitende Streifen 73 miteinander verbunden. Im Unterschied zur oben genannten Variante muß der Oszillator 6 eine in Normalenrichtung zur Elektrode vorhandene Zweirichtungspolarisation der zwischen den Elektroden 50 und 51 liegenden Piezokeramik haben, wie es mit den Pfeilen symbolisiert ist.

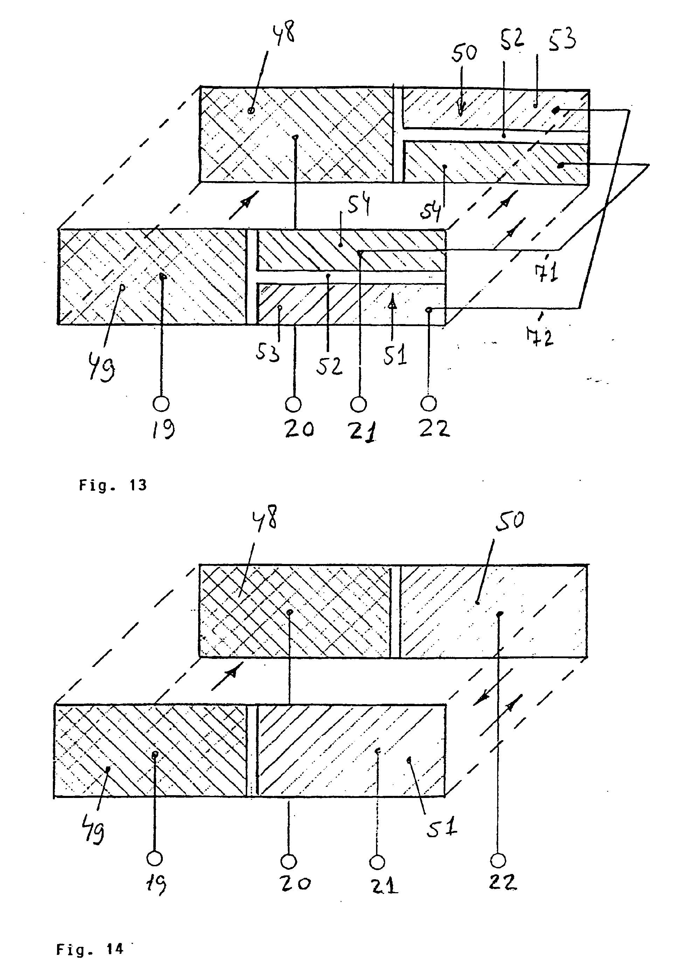

Der Oszillator gemäß Fig. 13 besitzt einen Längswellengenerator 17 und einen Biegewellengenerator 18 (siehe auch Fig. 10).
Der Oszillator gemäß Fig. 14 ist analog zu dem vorherigen aufgebaut, weist aber im Unterschied hierzu eine in Normalenrichtung zu den Elektroden 50 und 51 vorhandene Zweirichtungspolarisation der zwischen den Elektroden und der zweiten Elektrodengruppe 13 liegenden Piezokeramik auf. Diese bilden einen Generator 18 für stehende akustische Biegewellen.

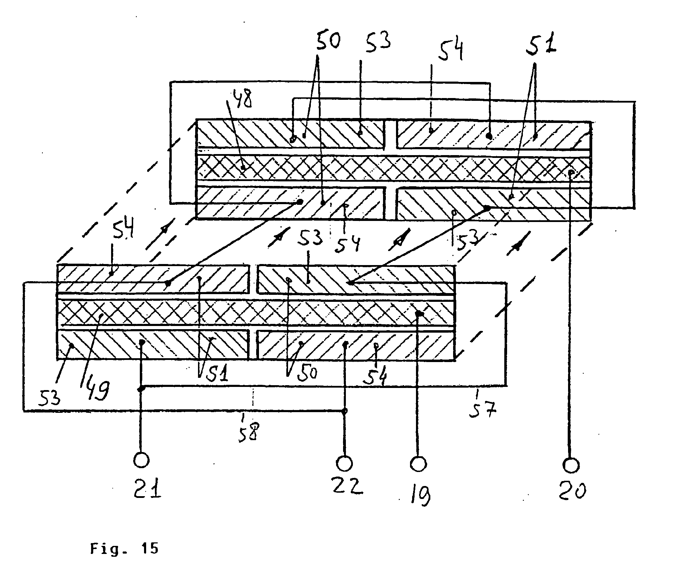

Beim Oszillator gemäß Fig. 15 sind zwei Biegewellengeneratoren 18 und ein Längswellengenerator 17 analog zu dem in Fig. 9 dargestellten Wandler vorhanden. Der Generator 17 wird durch die erste, die Elektroden 48, 49 einschließende Elektrodengruppe 12 gebildet. Die zwei Generatoren 18 entstehen durch die zwei Elektrodengruppen 13, die die Elektroden 50, 51 und die Elektrodenteile 53, 54 und die isolierenden Zwischenbereiche einschließen.

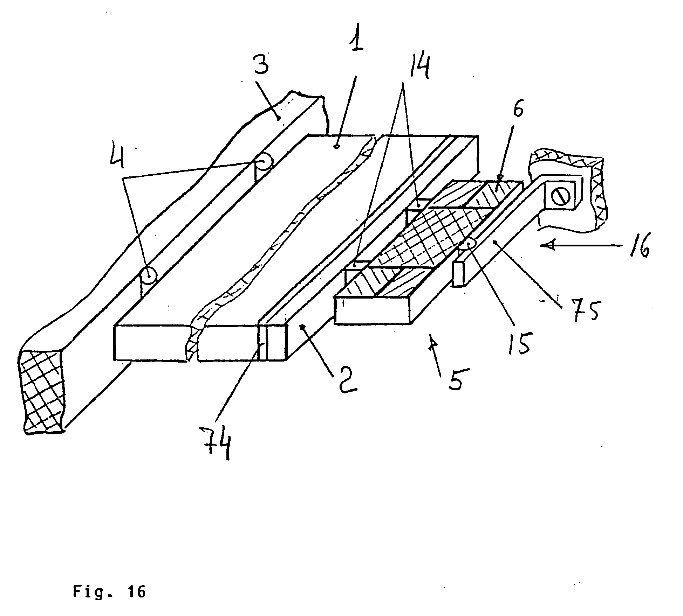

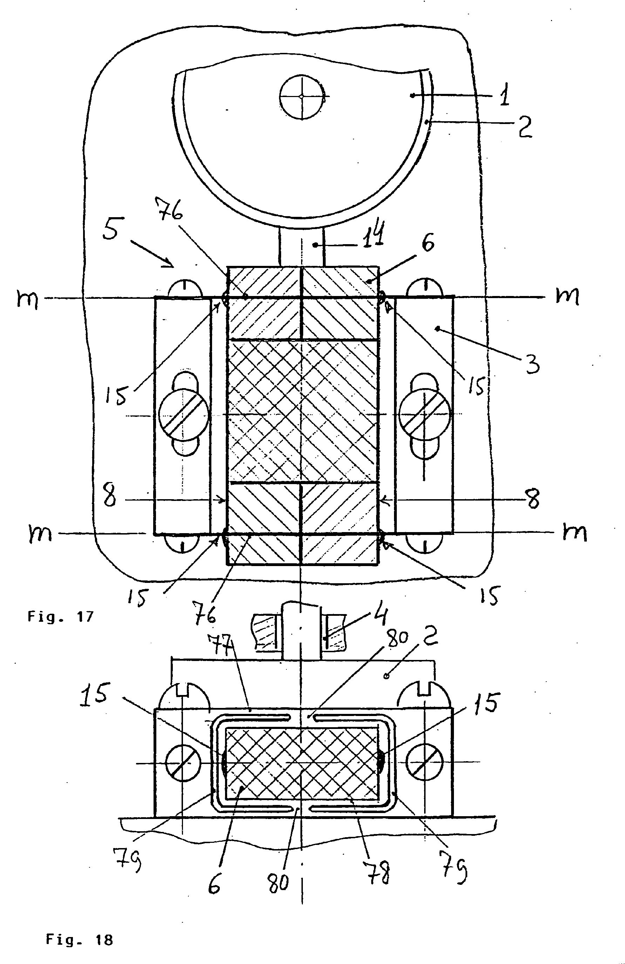

Fig. 16 offenbart eine der Ausführungsvarianten des vorgeschlagenen Motors, bei dem als das treibende Element 5 ein Translationsbewegungen des getriebenen Elements ausübender 1/2-Modenoszillator vom Längstyp Verwendung findet. Bei dieser Ausführungsvariante des Motors kann ein Oszillator 6 verwendet werden mit den in den Fig. 11 bis 15 dargestellten Elektrodengruppenkonfigurationen. In dem in den Fig. 17 und 18 dargestellten piezoelektrischen Motor ist das Anpressen der Friktionselemente 14 des Oszillators 6 an die Friktionsschicht sowie die Querfixierung des Oszillators 6 von fixierenden Elementen 12 realisiert. Im einzelnen sind zwei biegende Resonanzplatten 76 vorhanden. Die Resonanzplatten 76 sind fest an den kleinen Oberflächen 8 des Oszillators 6 längs der Linien m und am Motorgehäuse befestigt. Jede Resonanzplatte 76 besitzt einen äußeren 77 und einen inneren 78 Rahmen und es sind-teilende Zwischenspalte 79 und zwei verbindende Brücken 80 vorhanden.

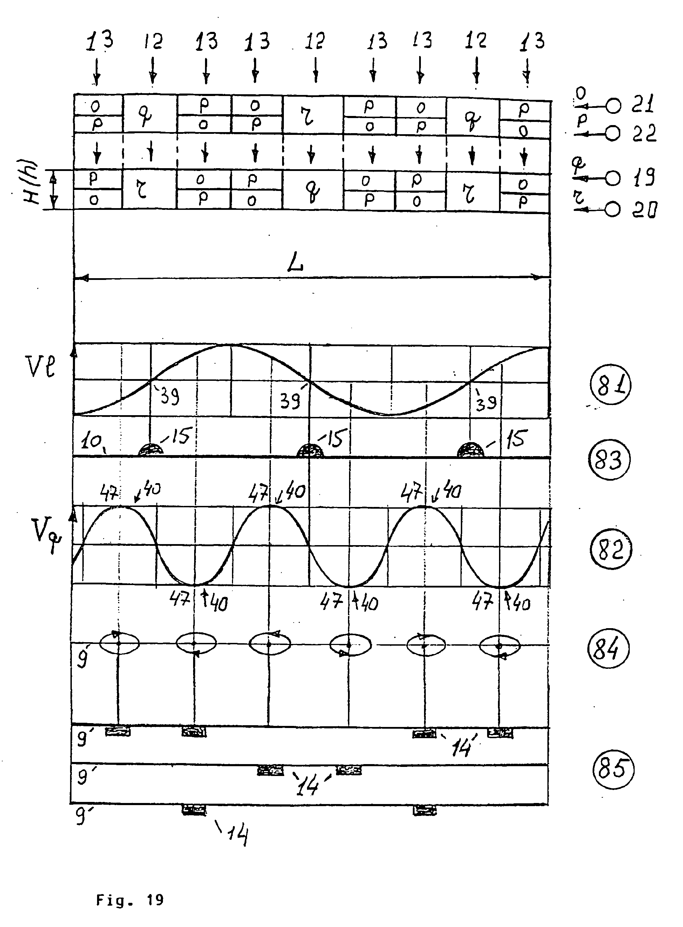

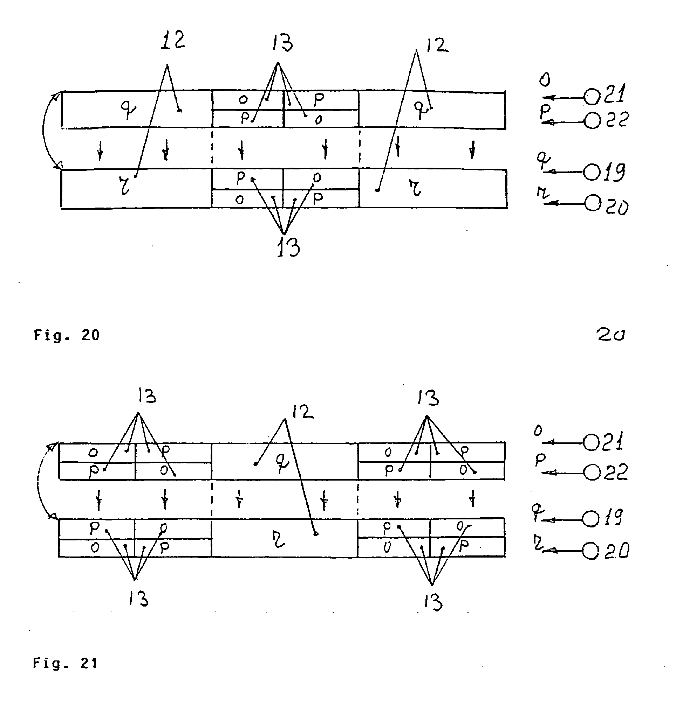

In den Fig. 19 bis 21 sind Elektrodenkonfigurationen eines 3/6-Modenoszillators 6 gezeigt. Alle durch o, p, q, r gekennzeichneten Elektroden sind mit Anschlußleitungen 21, 22, 19, 20 verbunden, die durch gleiche Buchstaben gekennzeichnet sind. Der Oszillator 6 mit der in Fig. 19 dargestellten Elektrodenkonfiguration besitzt drei Generatoren von stehenden Längswellen und vier Generatoren von stehenden Biegewellen. Der Oszillator 6 mit der in Fig. 20 dargestellten Elektrodenkonfiguration besitzt zwei Generatoren von stehenden Längswellen und einen Generator von stehenden Biegewellen.

Der Oszillator 6 mit der in Fig. 21 dargestellten Elektrodenkonfiguration besitzt einen Generator von stehenden Längswellen und zwei Generatoren von stehenden Biegewellen.

In Position 81 und 82 nach Fig. 19 sind Diagramme der Verteilung von Schwingungsgeschwindigkeiten Vl und Vg längs der Linie L des 3/6-Modenoszillators 6 gezeigt. Position 83 offenbart die Lage der fixierenden Elemente 15 auf der oberen Oberfläche des Oszillators 6. Die Position 85 zeigt Bewegungsbahnen von den Punkten, die sich an den Orten 47 von Schwingungsgeschwindigkeitsmaxima der stehenden Biegewelle auf der unteren Oberfläche 9 des Oszillators 6 befinden. Die Position 85 stellt mögliche Lagen von Friktionselementen 14 auf der Oberfläche 9 des Oszillators 6 dar.

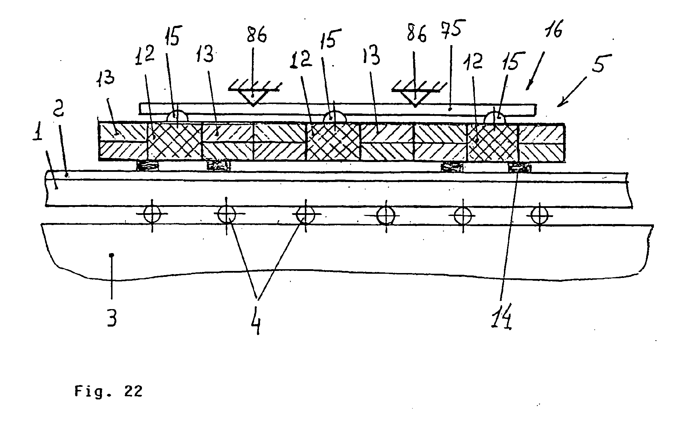

Fig. 22 ist eine Ausführungsvariante des piezoelektrischen Motors mit dem 3/6-Modenoszillator. Die Konfiguration der Elektrodengruppen kann wie in den Fig. 19, 20 oder 21 gezeigt ausgeführt sein. Der Oszillator 6 dieses Motors schließt vier Friktionselemente 14 und drei Fixationselemente 15 ein. Die Fixationselemente 15 sind in den drei Knoten 39 der stehenden Längswelle angeordnet. Diese sind mit Hilfe einer Anpreßvorrichtung 16 bezüglich des Gehäuses fixiert. Die Anpreßvorrichtung 16 kann aus einer flachen Feder 66 und zwei festen Trägern 86 bestehen. Die Positionen 87, 88, 89, 90, 91 und 92 stellen mögliche Friktionselemente 14 und deren Ausführungsformen dar. Die Friktionselemente 14 werden in Form von dünnen Streifen aus einer harten verschleißfesten Werkstoffkomponente, z.B. Oxidkeramik, Metallkeramik oder aus Kombinationen mit anderen Werkstoffen gefertigt. Außerdem können hierzu Werkstoffe auf der Grundlage von Aluminiumoxid, Zirkonoxid, Siliziumkarbid oder ähnlichen Materialien Verwendung finden.

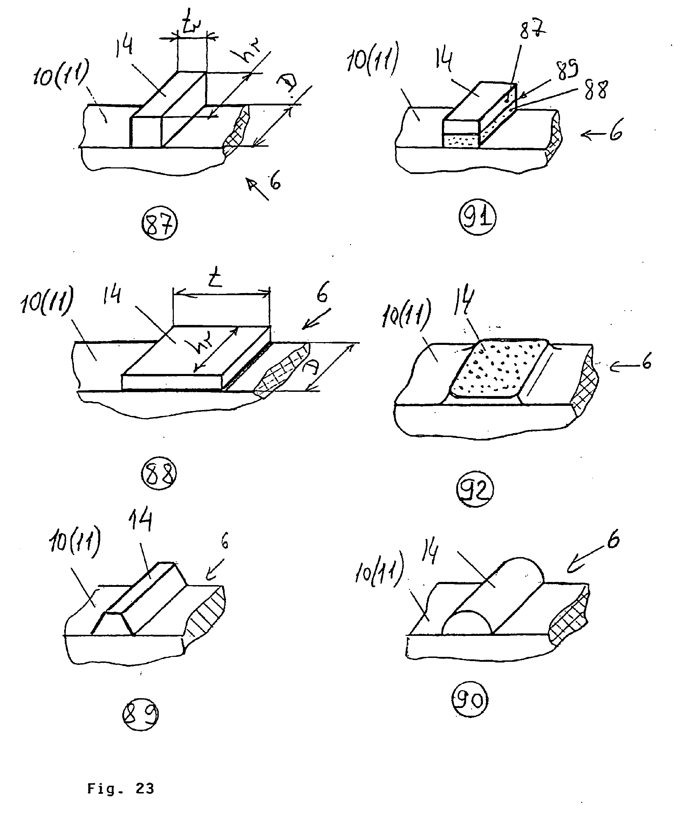

Die Ausführungsform der Friktionselemente 14 kann unterschiedlich sein. So können diese die Form von Rechtecken, Quadraten, Trapezen oder halbsphärischen Elementen besitzen (siehe Fig. 23).

Die Breite tr der Friktionselemente muß ungefähr fünfmal kleiner als die Halbwellenlänge λt/2 der sich im Oszillator 6 ausbreitenden akustischen Biegewelle sein.

Die Höhe hr der Friktionselemente 14 ist in den meisten Fällen gleich der Oszillatordicke D. Die Friktionselemente 14 sind fest an den unteren Oberflächen des Oszillators 6 befestigt, und zwar an den Punkten der eindeutigen Maxima von den Schwingungsgeschwindigkeiten 47 der akustischen stehenden Biegewelle, so wie es in den Fig. 3, 9 und 19 beispielsweise gezeigt ist.

Außerdem kann das Friktionselement an den Seitenoberflächen 8 des Oszillators 6 befestigt werden, so wie es in Fig. 10 gezeigt ist.

Die Friktionselemente 14 können eine Ein- (Fig. 23 Pos. 87, 88, 89, 90), Zwei- oder Drei-Schichtstruktur haben (Fig. 23 Pos. 91).
Bei einer Zwei-Schichtstruktur des Friktionselements 14 wird die erste Schicht 87 aus einer verschleißfesten Materialkomponente mit einem hohen Reibungskoeffizienten im Vergleich zur Friktionsschicht 2 des getriebenen Elements 1 gefertigt. Die zweite Schicht 88 besteht aus einer harten, porösen Materialkomponente. Beide Schichten 87 und 88 sind durch Verschweißen beim Sintervorgang miteinander verbunden, so daß in dem Verbindungsbereich der ersten 87 und der zweiten 88 Schicht eine dritte, dazwischen liegende Übergangsschicht 89 gezielt gebildet werden kann.

Das Befestigen des Friktionselements 14 an den kleinen Oberflächen 10 und 11 des Oszillators 6 kann mit Hilfe von organischen Epoxidharzklebstoffen durchgeführt werden. Auch ist eine Verbindung durch chemische Reaktion, z.B. mit leichtschmelzendem bleihaltigen Glas denkbar.

In den genannten Fällen können Poren der zweiten Schicht 88 des Friktionselements 14 mit einem Verbindungsstoff ausgefüllt oder aufgefüllt werden, so daß eine optimierte Kontaktierung entsteht.

Des weiteren können die Friktionselemente 14 in Form von Glasstreifen gebildet werden, die auf die Oberflächen 10 und 11 des plattenförmigen piezoelektrischen Oszillators aufgeschmolzen sind. Das Glas wird mit Pulver eines harten, verschleißfesten Werkstoffs versehen, z.B. Aluminiumoxid, Zirkonoxid, Siliziumkarbid, Titankarbid oder ähnlichen Materialien oder ihrer Gemische.

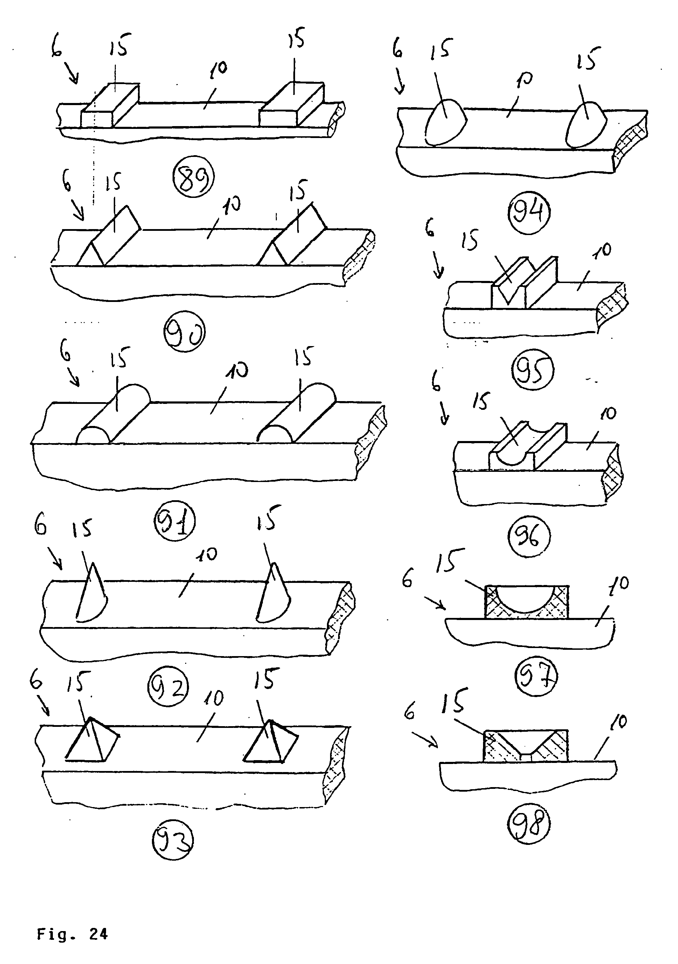

Fig. 24 Position 89 bis 98 zeigt denkbare Ausführungsformen von fixierenden Elementen. Diese können als rechteckige Prismen 89, dreieckige Prismen 90, halbzylindrische Prismen 91 oder konische Elemente 92, pyramidenförmige Element 93, halbsphärische Elemente 94, rechteckige Elemente mit Profilnuten 95, 96, runde Elemente mit Profilbohrungen 97, 98 oder als ähnliche Elemente ausgeführt werden.

Die in Fig. 24 dargestellten Fixationselemente 15 können aus einem Werkstoff gefertigt werden, dessen Elastizitätsmodul ungefähr gleich oder ein wenig größer als der E-Modul der Piezokeramik des Wandlers 6 ist. Sie können aus einem Werkstoff bestehen, dessen Elastizitätsmodul viel kleiner als der E-Modul der Piezokeramik des Wandlers ist. Die Elemente können aber auch aus demselben Piezokeramiktyp wie der Wandler selbst gefertigt werden. Die fixierenden Elemente 15 oder Teile von diesen, die mit der Oberfläche des Oszillators 6 in Kontakt kommen, können aus einer porösen Oxidkeramik oder einem anderen porösen Material bestehen.

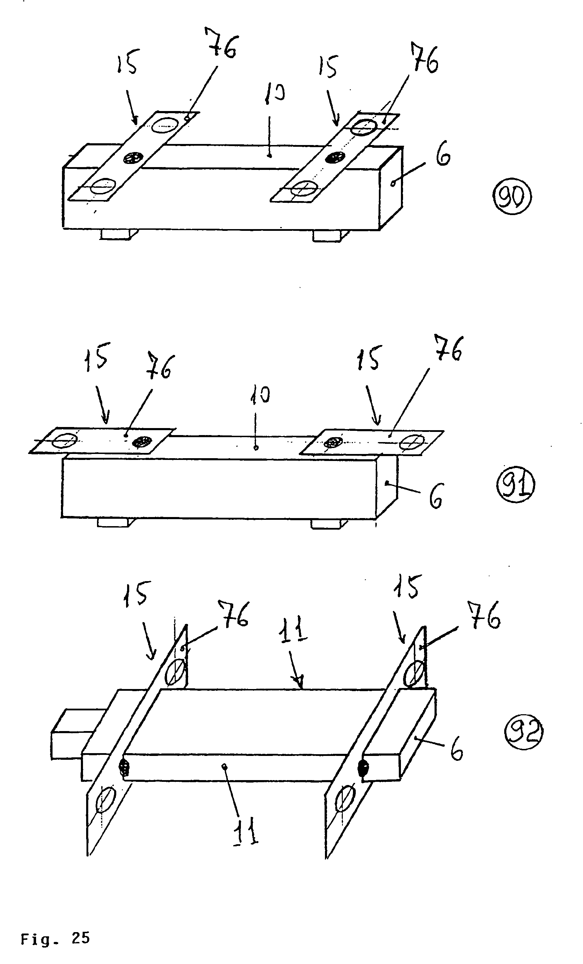

Fig. 25 Position 90 bis 92 zeigt fixierende Elemente 15 in Form von biegefähigen Resonanzplatten 76. Die Position 90 offenbart eine quer- und die Position 91 eine längsartige Befestigung der Resonanzplatten 76. In Position 92 sind die biegenden Resonanzplatten 76 dargestellt, die in Form von zwei, den Oszillator 6 umfassenden Rahmen ausgeführt sind.

Beim vorgeschlagenen Antrieb sind die fixierenden Elemente 15 starr mit der Oberfläche 9 des Oszillators oder Wandlers 6 verbunden. Eine solche Verbindung kann mit Hilfe von organischen Klebern, z.B. auf Epoxidharzbasis ausgeführt werden. Außerdem kann eine Verbindung mit der Oberfläche 10 des Oszillators unter Rückgriff auf einen Stoff erfolgen, der eine chemische Kontaktierung zwischen piezoelektrischer Keramik und dem Material des fixierenden Elements 15 eingeht oder ermöglicht.

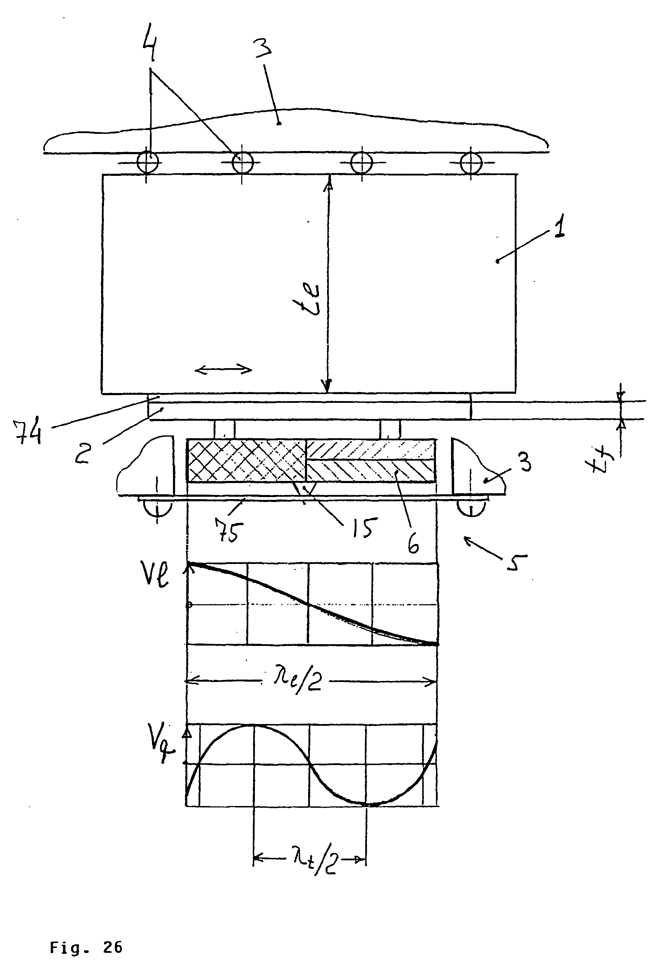

Fig. 26 zeigt eine der Ausführungsvarianten des vorgeschlagenen Motors, bei dem die Friktionsschicht 2 als eine Oxidkeramikschicht ausgebildet ist, die eine Dicke tf aufweist, die mindestens fünfmal kleiner als die halbe Längswelle λl der sich im plattenförmigen Oszillator ausbreitenden stehenden Längswelle ist. Bei einem solchen piezoelektrischen Motor kann die Dicke tl des Körpers des getriebenen Elements 2 größer als eine Halbwellenlänge λt der akustischen Biegewelle sein, die sich im Wandler 6 ausbildet.
Zwischen dem Körper des getriebenen Elements 1 und seiner Friktionsschicht 2 kann eine Dämpfungsschicht 74 angeordnet sein, die aus einem schalldämpfenden Material besteht.

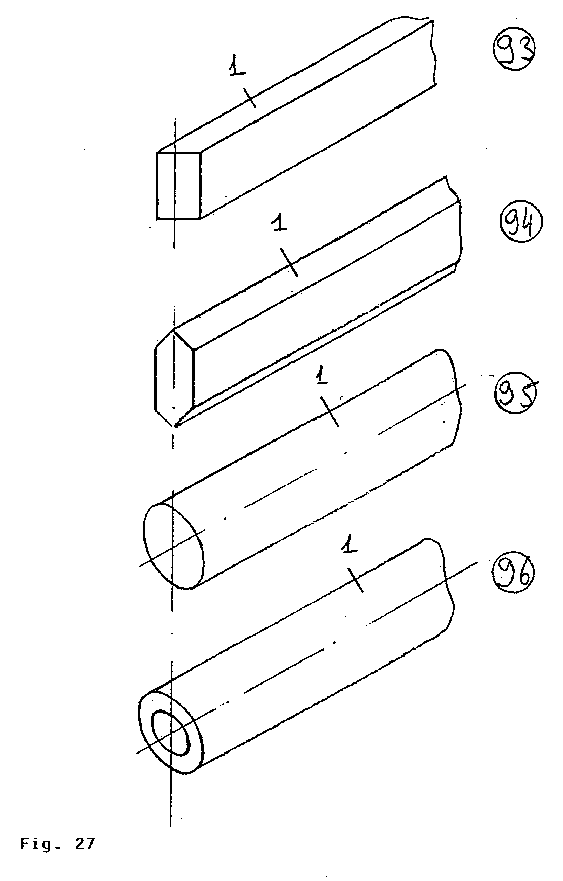

Fig. 27 zeigt Ausführungsvarianten des getriebenen Elements in Form eines Balkens mit einer rechteckigen, viereckigen oder runden Querschnittsform bzw. als ein Rohr, wobei hier auf die Positionen 93 bis 96 zu verweisen ist.

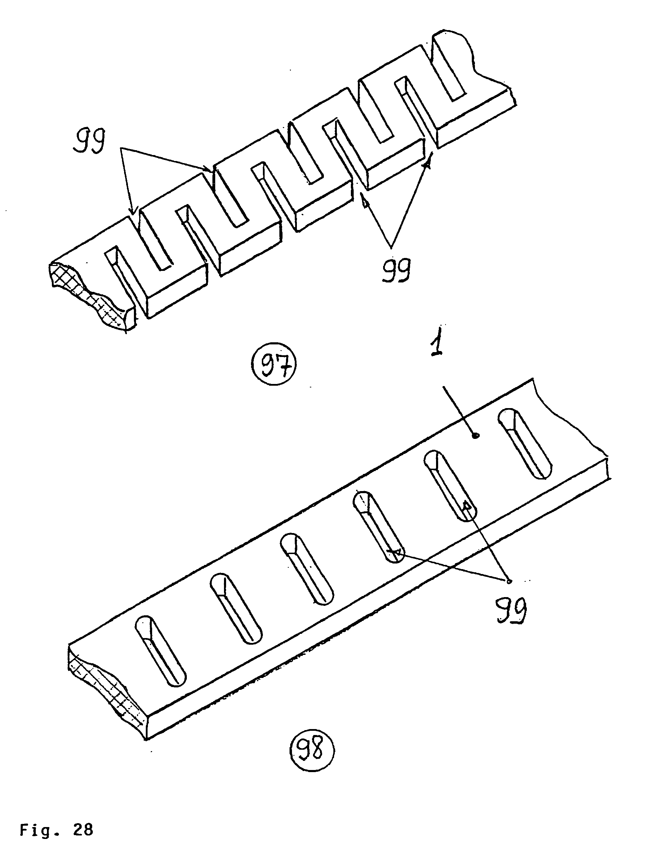

Die Fig. 28 mit den Positionen 97 und 98 zeigt Ausführungsvarianten der getriebenen Elemente, deren Körper periodisch mit dämpfenden Nuten 99 oder entsprechenden Ausnehmungen 99 versehen sind. Das getriebene Element in den Fig. 27 oder 28 kann aus einem harten porösen Werkstoff bestehen. Dabei können die Poren mit einem schalldämpfenden Stoff, z.B. Silikon oder Gummi verfüllt werden.

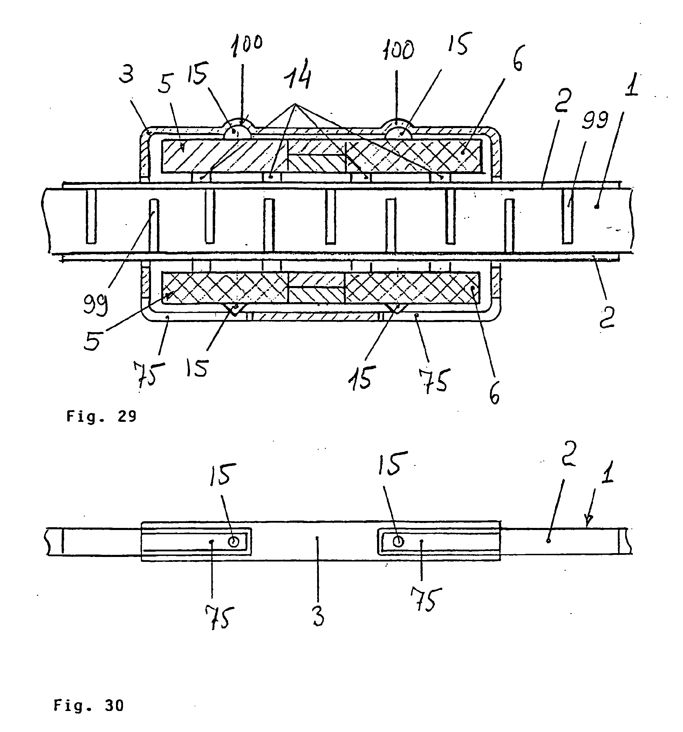

Die in der Fig. 29/30 dargestellte Ausführungsvariante des Motors schließt zwei gegenüberstehende Wandler 6 und zwei Friktionsschichten 2 ein. Diese liegen in einer Ebene und parallel zueinander an den gegenüberliegenden Seiten des getriebenen Elements 1.

Bei dieser Ausführungsvariante des Motors sind halbsphärische Elemente 15 eines Oszillators in halbsphärischen Trägern 100 befindlich. Die Träger 100 sind als Vertiefungen im Gehäuse 3 ausgeführt. Dier zweite der Oszillatoren 6 besitzt konisch ausgebildete fixierende Elemente 15, auf welche die Kraft von zwei flachen Federn 75 wirkt, die die Friktionselemente 14 an die Friktionsschicht 2 des getriebenen Elements 1 pressen.

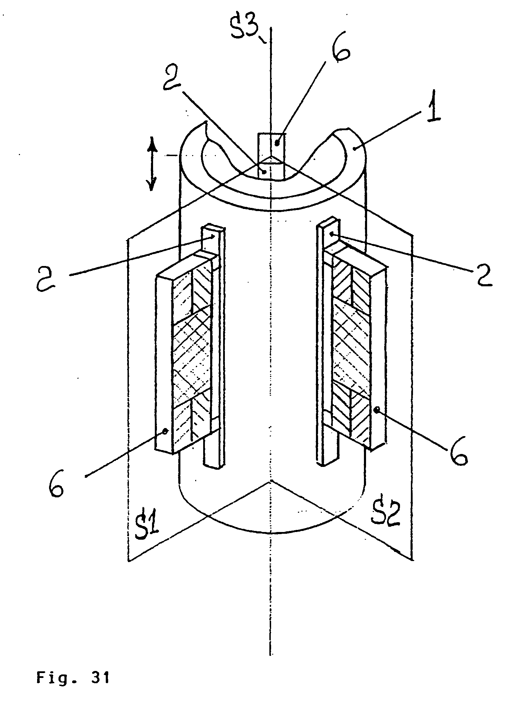

Bei der Ausführungsvariante nach Fig. 31 ist ein Antrieb gezeigt, bei welchem drei Wandler 6 und drei Friktionsschichten 2 ausgebildet sind. Diese sind in drei Ebenen S1, S2 und S3 angeordnet.

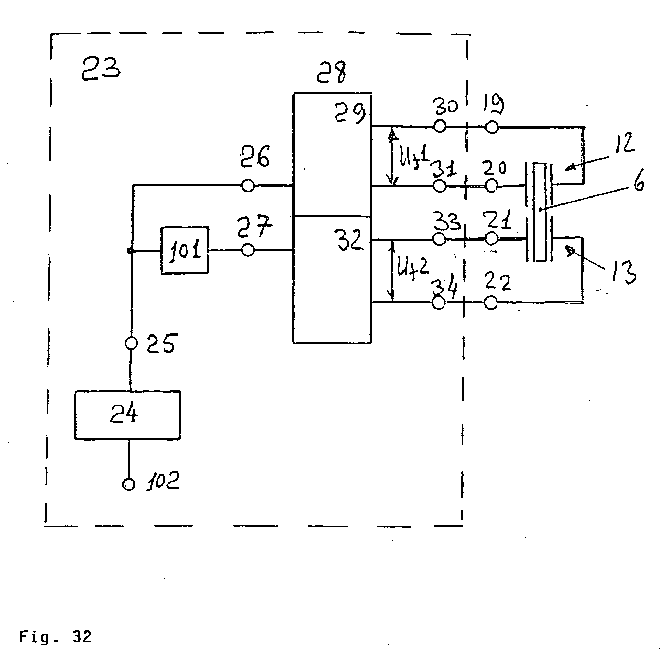

Fig. 32 zeigt eine einfache Ausführungsform einer Erregungsquelle 23. Der Ausgang 25 des Grundgenerators 24 ist mit einem der Signaleingänge 27 oder 26 des Zweikanal-Leistungsverstärkers 28 über einen Phasenschieber 191 verbunden. Der Grundgenerator 24 besitzt einen Steuerungseingang für die Erregungsfrequenz 102.

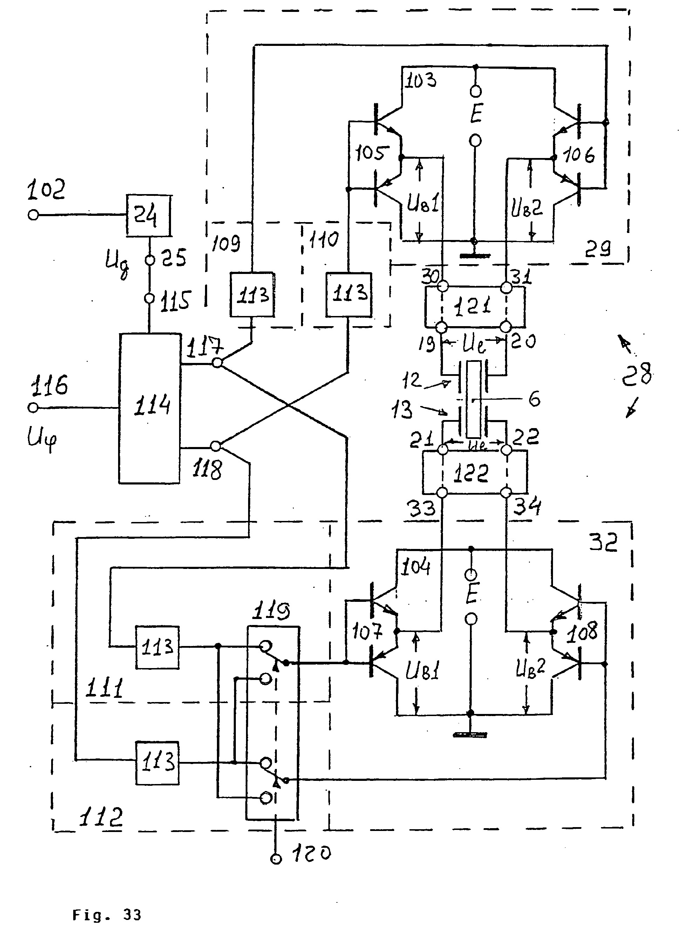

Eine weitergebildete Variante zur elektrischen Erregung zeigt die Fig. 33. Hier sind der erste 29 und der zweite 32 Kanal des Leistungsverstärkers 28 in Form von Brückenleistungsverstärkern 103 und 104 mit den Gleichspannungsquellen E ausgeführt.
Jeder der Verstärker 103, 104 enthält zwei Halb-Brückenverstärker 105, 106 unsd 107, 108 mit den Erregungskanälen 109, 110 und 111, 112, die mit dem Signalphasensteuerer 114, Steuereingang 116, Stützspannungseingang 117 und mit dem Ausgang der phasenvariablen Spannung 188 ausgestattet sind.
Einer der Kanäle 29 oder 32 des Leistungsverstärkers kann einen elektronischen Umschalter 119 mit Steuereingang 120 haben, welcher eine Ausgangsumschaltung der Erregungskanäle ermöglicht.
In dieser Ausführungsvariante sind die Anschlüsse 19, 20 der ersten Elektrodengruppe 12 des Wandlers 6 an die Ausgänge 30, 31 des ersten Kanals 29 des Leistungsverstärkers 28 über ein Filter 121 angeschlossen.
Die Anschlüsse 21, 22 der zweiten Elektrodengruppe 13 sind an die Ausgänge 33, 34 des zweiten Kanals 32 des Leistungsverstärkers 29 über das Filter 122 angeschlossen.

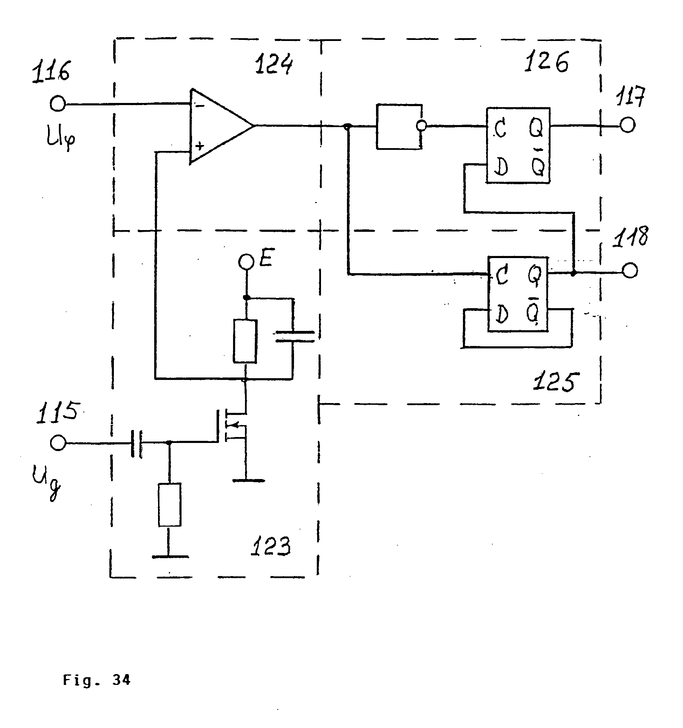

Fig. 34 offenbart eine Ausführungsvariante des Phasensteuerers 114. Dieser enthält ein Sägezahnspannungsformierglied 123, einen Pulsdauermodulator 124, einen Stützspannungsformer 125 und einen Former für die phasenvariable Spannung 126.

Fig. 35 macht die Abhängigkeit der Phasenverschiebung ϕ_{B} zwischen der am Ausgang 117 und 118 des Phasensteuerers 114 liegenden Spannungen von der Steuerspannung U_{ϕ} am Ausgang 116 deutlich. Mit der gestrichelten Linie ist eine weitere Variante der Abhängigkeit der Phasenverschiebung gezeigt.

In Fig. 36 sind Diagramme der Spannung U_{B}1 zwischen dem Ausgang 30 oder 33 und Masse sowie der Spannung Ue zwischen den Anschlüssen 19 und 20 oder 21 und 22 dargestellt. Die Positionen 127 bis 129 entsprechen den unterschiedlichen Werten der Phasenverschiebung ϕB1, ϕB2, ϕB3, denen verschiedene Spannungswerte Ue1, Ue2, Ue3 zugeordnet sind.

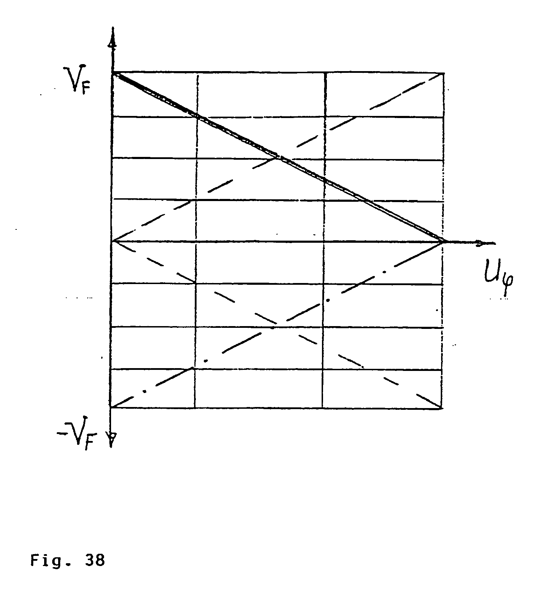

Fig. 37 zeigt die Abhängigkeit der Phasenverschiebung ϕ_{B} des Phasensteuerers 114 von der Spannung Ue, wobei die Fig. 38 die Abhängigkeit der Bewegungsgeschwindigkeit Vf des getriebenen Elements 1 von der Steuespannung Uϕ zeigt.

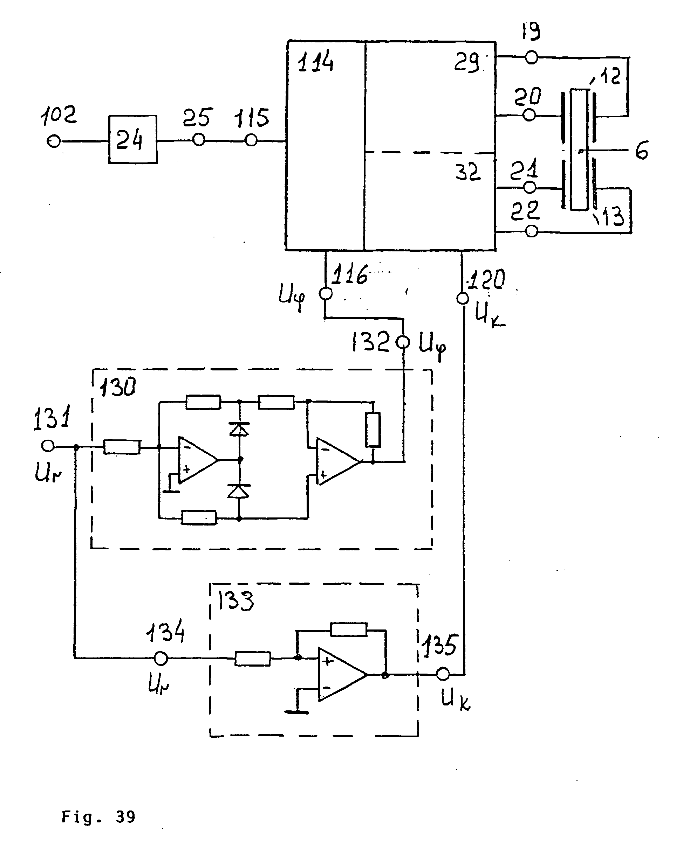

Die in der Fig. 39 dargestellte Variante der Erregungsquelle 23 ist zusätzlich mit einem Signalpegelwandler für das Steuersignal 130 ausgestattet. Diese Variante enthält den Steuereingang 131, den Ausgang 132 und den Nullsignaldetektor 133 des Steuersignals mit Steuereingang 134 und Steuerausgang 135.

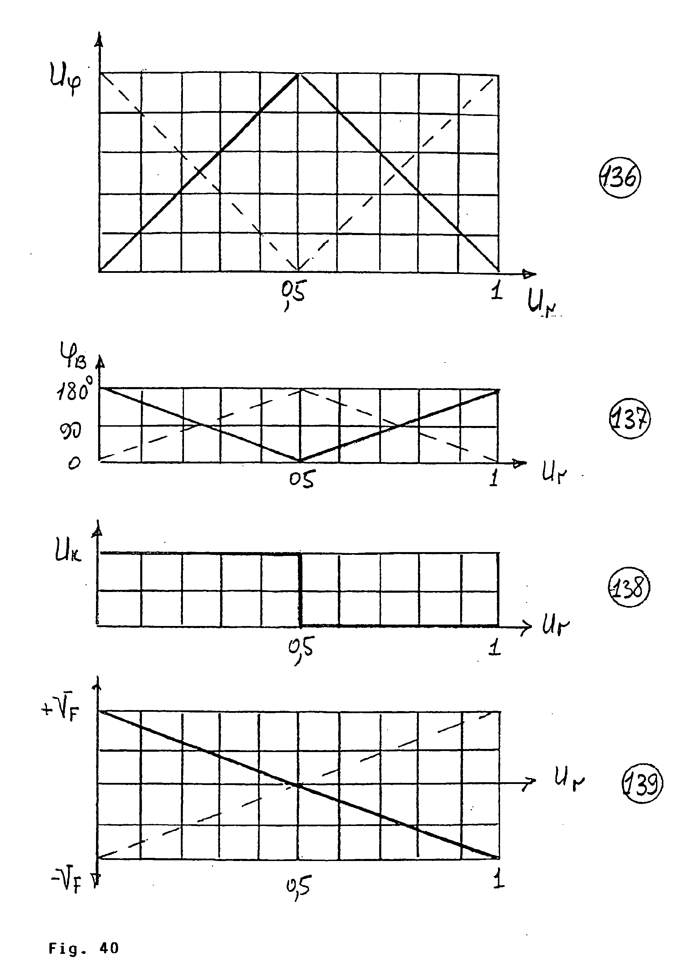

Fig. 40 zeigt Spannungsdiagramme der in Fig. 39 dargestellten Ausführungsvariante der Erregungsquelle. Das Diagramm mit der Position 136 offenbart die Abhängigkeit zwischen der Spannung Uϕ an dem Ausgang 132 des Signalpegelwandlers der Steuerspannung 130 und der Spannung Ur am Ausgang 131.
Das Diagramm mit Position 137 zeigt die Abhängigkeit zwischen dem Phasenverschiebungswinkel ϕ_{B} und der Steuerspannung Ur des Phasensteuerers 114. Das Diagramm mit der Position 138 läßt die Abhängigkeit zwischen der am Ausgang 135 des Nullsignaldetektors des Steuersignals liegenden Spannung 133 und der Steuerspannung Ur an seinem Ausgang 134 erkennen. Das Diagramm mit der Position 139 offenbart die Abhängigkeit zwischen der Bewegungsgeschwindigkeit Vf des getriebenen Elements 1 von der Steuerspannung Ur.

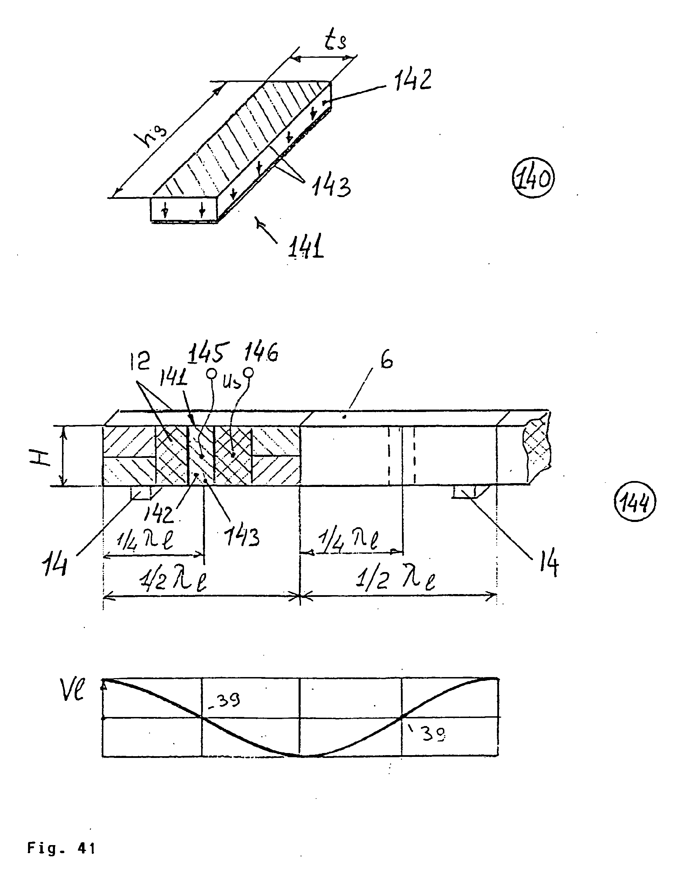

Die Position 140 nach Fig. 41 zeigt eine Ausführungsvariante des Sensors zur Bestimmung der Komponente mechanischer Längsspannungen 141. Der Sensor 141 ist in Form einer piezoelektrischen Platte 142 ausgeführt, die eine Dicke im Bereich von 0,1 bis 0,3 mm besitzt.
Die Platte 142 besitzt auf ihrer großen Oberfläche eine Elektrode 143 und ist in Normalenrichtung zu dieser Elektrode 143 polarisiert.

Die Breite t_{S} der Platte ist ungefähr zehnmal kleiner als eine Halbwellenlänge der im Wandler 6 entstehenden Längswelle. Die Höhe h_{S} kann gleich oder größer als die Oszillatorbreite h sein.

Position 144 nach Fig. 41 zeigt eine Befestigungsmöglichkeit des Sensors nach Position 140 auf dem piezoelektrischen Wandler 6. Der Sensor 141 wird auf einer der großen Oberflächen 7 des Wandlers 6 angebracht, und zwar an dem Ort eines der Schwingungsgeschwindigkeitsknoten 38 der sich im Wandler 6 symmetrisch bezüglich der Längsache ausbreitenden Biegewelle.

Der plattenförmige Sensor 142 wird z.B. an die Oberfläche des Wandlers 6 geklebt oder dort angelötet.

Der Sensorausgang 145 wird an seine obere Elektrode 143 und der Ausgang 146 am Wandler 6 angeschlossen.

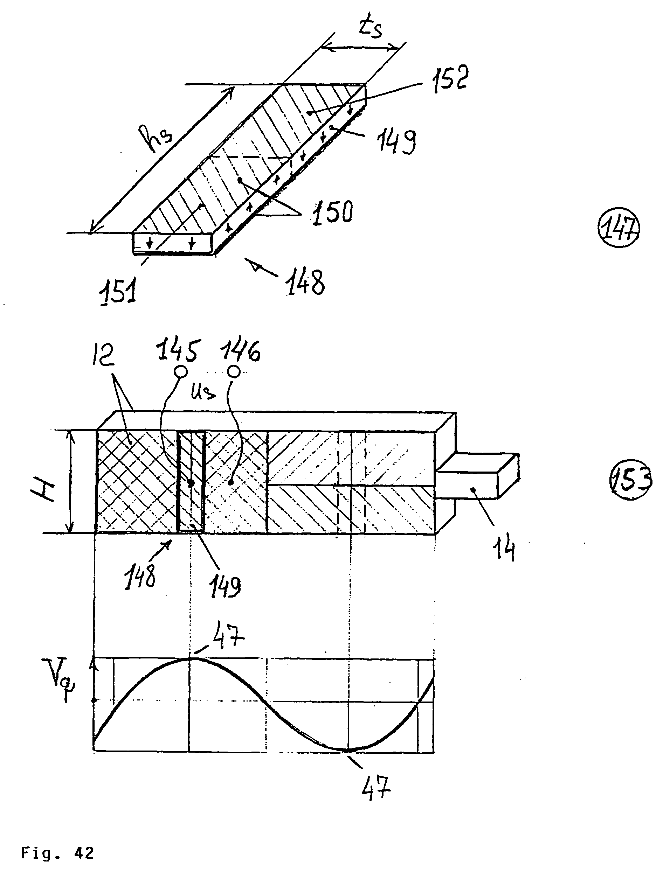

Position 147 nach Fig. 42 zeigt den Sensor 148 zur Bestimmung von Komponenten mechanischer Biegespannungen. Dieser Sensor wird nur gemeinsam mit Oszillatoren vom Längstyp nach Fig. 10 eingesetzt. Der Sensor selbst ist in Form einer piezoelektrischen Platte 149 mit einer Dicke im Bereich von 0,1 bis 0,3 mm ausgeführt. Die Plattenhöhe h_{S} ist gleich der Oszillatorbreite H. Die Platte hat an ihrer großen Oberfläche ununterbrochene Elektroden 150. Die Platte 143 ist bezüglich der Abmessung h_{S} in zwei gleiche Teile 151 und 152 geteilt. Diese Teile sind in Normalenrichtung zur Elektrodenoberfläche, aber mit einer verschieden gerichtet polarisierten Piezokeramik ausgeführt, so wie es in der Position 147 mit den Pfeilen symbolisiert ist. Der Sensor 148 wird an der großen Oberfläche 7 des Oszillators 6 angebracht, und zwar an dem Ort eines der Schwingungsgeschwindigkeitsmaxima 47 der stehenden akustischen Biegewelle und symmetrisch bezüglich der Längsachse des Wandlers 6 (siehe Fig. 41, Pos. 153). Das Fixieren des Sensors 148 geschieht auf die gleiche Weise wie zum Sensor 141 beschrieben.

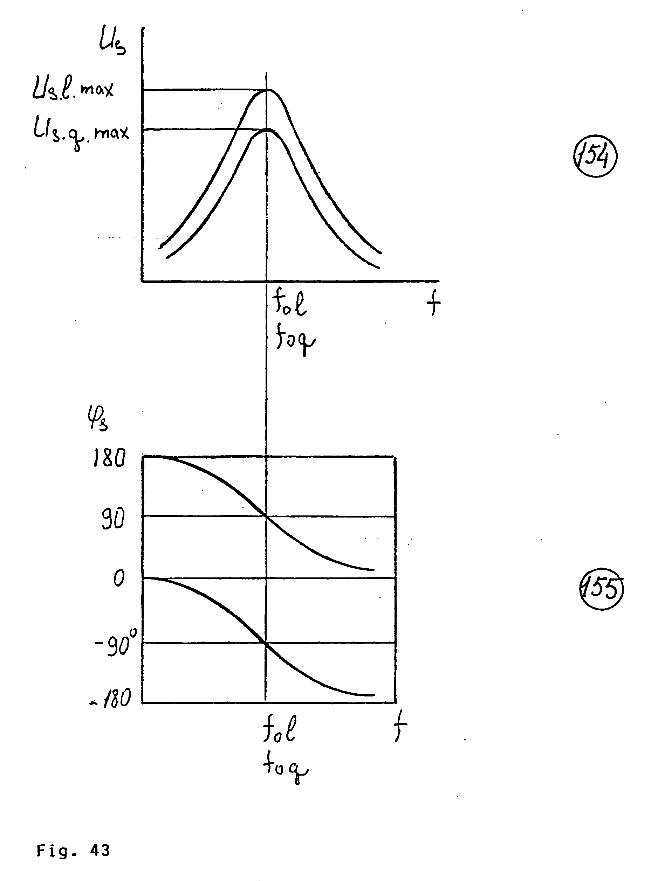

Fig. 43, Position 154, zeigt Frequenzabhängigkeiten der elektrischen Spannungen Usl und Usg an den Elektroden 154, 150 er Sensoren 141, 148. Deren maximalwerte Uslmax und Usg max entsprechen den Resonanzfrequenzen der Längs- und Biegeschwingungen des Wandlers 6 (fₒₗ sowie f_{og}) .

Die Position 155 nach Fig. 43 zeigt die Abhängigkeit des. Phasenverschiebungswinkels ϕs zwischen der Erregungsspannung Ue und der Spannung Usl oder Usg an den Elektroden 143 oder 150 der Sensoren 141 oder 148. Die Abhängigkeiten sind entsprechend der Orientierung der Sensoren bezüglich der Polarisationsrichtung unterschiedlich.

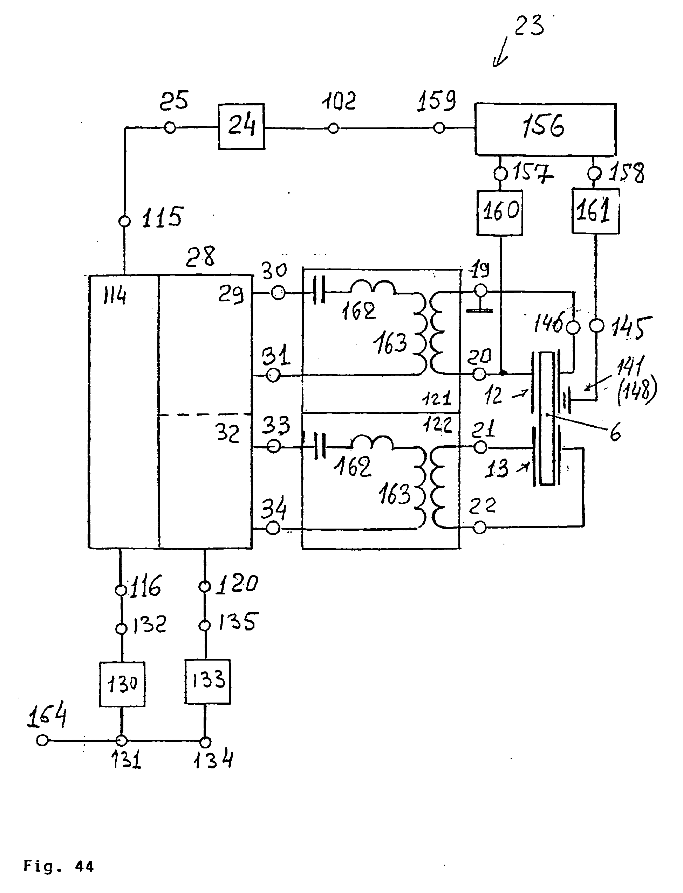

Die Fig. 44 zeigt eine Schaltungsvariante, bei der die Quelle der elektrischen Erregung von akustischen Schwingungen 23 mit einem Phasendetektor 156 versehen ist. Dieser enthält den Stützeingang 157 und den Meßeingang 158 sowie den Ausgang 159. Der Stützeingang 157 des Phasendetektors 156 ist über ein Stützsignalformierglied mit dem Anschluß 20 der ersten Elektrodengruppe 12 oder mit dem Anschluß 21 der zweiten Elektrodengruppe 13 verbunden. Der Meßeingang 158 ist über ein Signalformierglied 161 mit dem Anschluß 145 des Sensors 141 oder des Sensor 148 verbunden. Der Ausgang des Phasendetektors 149 ist am Steuerungseingang der Erregungsfrequenz 102 des Grundgenerators 24 angeschlossen. Bei dieser Variante sind die Filter 121 und 122 in Form eines LC-Glieds 162 und unter Verwendung eines summierenden Transformators 163 ausgeführt. Der Antrieb besitzt den gemeinsamen Steuerungseingang 164.

Der bei den Ausführungsbeispielen beschriebene Motor oder Antrieb beruht auf der gleichzeitigen voneinander unabhängigen elektrischen Erregung eines piezoelektrischen Wandlers hinsichtlich der stehenden Längs- und stehenden reinen Biegewelle. Bei den verschiedenen Varianten können die erste, zweite, dritte und vierte der Moden der Längswelle mit den zweiten, dritten, vierten, fünften, sechsten und siebten Moden der Biegewelle kombiniert werden.
Die Modenkombination wird durch das Verhältnis der Länge L zu der Breite H des Wandlers 6 bestimmt, das für die ausgewählte Modenkombination konstant und unabhängig vom Piezokeramiktyp ist. Als Orientierung kann vorgegeben werden, daß das Verhältnis L/H für den 2/5-Modenoszillator ungefähr 10, für den 1/2-Modenoszillator ungefähr 4 und für den 3/6-Modenoszillator ungefähr 8 ist. Bei einer optimalen Wahl des Verhältnisses L/H sind die Resonanzfrequenzen der Längsschwingungen und der Biegeschwingungen gleich, wie es die Fig. 2 symbolisiert. Ein zu großer Unterschied zwischen den Frequenzen fₒₗ und f_{og} weist auf eine unzureichende oder falsche Wahl des Verhältnisses L/H hin, was den Motorbetrieb nachteilig beeinflußt. Die Differenz Δf der oben genannten Frequenzen soll 1% im Regelfall nicht überschreiten.

Bei dem beschriebenen Motor wird die Erregung der akustischen Längswelle mit Hilfe von mindestens einem Generator erreicht, der durch eine erste Elektrodengruppe gebildet ist. Die Erregung der akustischen Biegewelle wird mit Hilfe von mindestens einem weiteren Generator erreicht, der durch die zweite Elektrodengruppe ausgeführt ist. Die Elektrodengruppenkonfigurationen sind so gestaltet, daß die Generatoren elektrisch und mechanisch nicht miteinander verbunden sind und daher reine Längs- bzw. Biegewellen erzeugen können. Unter einer reinen Biegewelle wird verstanden, daß diese keine Längskomponente besitzt. Eine reine Längswelle soll keine Biegekomponenten enthalten. Die Wirkung beider Wellen auf die Friktionselemente führt zu einer elliptischen Bewegung. Dabei haben die Punkte der Funktionsflächen der Friktionselemente nur gering voneinander unterschiedliche Bewegungsbahnen.

Bei der hinsichtlich der Fig. 1 beschriebenen Variante des Antriebs wird die benötigte zeitliche Phasenverschiebung zwischen den Wellen durch die Konstruktion des Wandlers bestimmt. Der Motor nach Fig. 1 enthält einen 2/5-Modenoszillator mit der in Fig. 4 dargestellten Elektrodengruppenkonfiguration. In einem solchen Oszillator bildet die erste Elektrodengruppe 12 Längswellengeneratoren 17 gleicher Phase. Diese erzeugen in dem Oszillator oder Wandler die zweite Mode der akustischen Längswelle. Die Verteilungsdiagramme der Schwingungsgeschwindigkeiten dieser Welle längs der Oszillatorlänge L sind in Fig. 3, Position 37 zu erkennen. Die zweite Elektrodengruppe 13 bildet einen Biegewellengenerator 18, der im Oszillator bzw. Wandler 6 die fünfte Mode der stehenden akustischen Biegewelle erzeugt. Entsprechende Verteilungsdiagramme zeigt die Position 38 der Fig. 3. Da die Amplituden der Längs- und Biegeschwingungen des Wandlers deutlich kleiner als seine Abmessungen sind, besitzen die Wellen keine störenden Wechselwirkungen, d.h. sie breiten sich im Oszillator oder Wandler 6 unabhängig voneinander aus. Aufgrund dieser gleichzeitigen Ausbreitung bewegen sich alle Punkte der Oszillatoroberflächen 8 auf elliptischen Bahnen. Die Form der Bewegungsbahnen und die Bewegungsrichtungen der Punkte ändern sich längs der Oszillatorlänge und sind von den Amplituden und Phasen der durch jede Welle hervorgerufenen Schwingungen der einzelnen Punkte abhängig.

Fig. 3 Position 42 zeigt Formen von Bewegungsbahnen und Bewegungsrichtungen von Punkten a, b, c, d, die sich an unteren Oszillatoroberflächen 9 in den Schwingungsgeschwindigkeitmaxima 47 der stehenden akustischen Biegewelle längs der zu seinen großen Oberflächen 7 senkrecht stehenden Linien befinden. In diesen Punkten ist die elliptische Bewegungsbahn längs der Oszillatorlänge L angeordnet. Die Bereiche der Maxima 47 erweisen sich als Optimum für das Anrbingen von Friktionselementen 12. In diesen Bereichen bewegen sich alle Punkte der Friktionselemente 12 praktisch auf gleichen Bahnen. Fig. 3, Position 42 bis 46 zeigt mögliche Lagen zum Befestigen von Friktionselementen 14, die den eindeutigen Maxima 47 entsprechen.

Die elliptischen Bewegungen der sich auf der unteren Oberfläche 9 befindlichen Punkte veranlassen die dort befindlichen Friktionselemente 14 zur elliptischen Bewegung. Da die Friktionselemente entsprechend elastisch mit der Friktionsschicht 2 des getriebenen Elements in Kontakt treten, entsteht eine entsprechende Einrichtungsbewegung des getriebenen Elements 1. Um eine Verschiebung des Wandlers 6 in eine in Richtung des getriebenen Elements entgegengesetzte Orientierung zu verhindern, ist dieser mit mindestens einem fixierenden Element 15 ausgestattet. Diese fixierenden Elemente 15 werden in Bereichen der Schwingungsgeschwindigkeitknoten 39 der stehenden akustischen Längswelle angebracht. In den Bereichen 39 ist die Schwingungsamplitude des Wandlers 6 klein, so daß minimale Verluste entstehen.

Die Konfigurationsvarianten der Elektrodengruppen 12 und 13 eines 2/5-Modenoszillators nach den Fig. 5 und 6 unterscheiden sich jeweils von der unterschiedlichen Anzahl von Generatoren 17 und 18 sowie durch die Erzeugung der Biegewelle.

Fig. 9 zeigt einen 1/2-Modenoszillator oder Wandler 6 vom Längstyp. Bei dem Typ ist der Wandler 6 längs der Friktionsschicht 2 angeordnet, so wie es auch in Fig. 16 dargestellt ist. Bei dem 1/2-Modenoszillator vom Quertyp nach Fig. 10 ist ein Friktionselement 14 im Zentrum einer der kleinen Seitenflächen des Oszillators befindlich. Der Oszillator oder Wandler 6 wird dabei quer oder senkrecht zur Friktionsschicht 2 ausgerichtet, so wie es die Fig. 17 und 18 zeigen.

Bei beiden Ausführungsvarianten des Motors werden im Wandler 6 mit Hilfe der Generatoren 17 und 18 erste Moden der Längswelle und zweite Moden der Biegewelle erzeugt. Die Ausbreitung dieser Wellen verursacht die gewünschte elliptische Bewegung der Friktionselemente 14, die das getriebene Element zu einer Einrichtungsbewegung veranlassen.

Konfigurationsvarianten der Elektrodengruppe 12 und 13 eines 1/2-Modenoszillators sind in den Fig. 11 bis 15 dargestellt. Die Fig. 19 bis 21 wiederum offenbaren Konfigurationsvarianten der Elektrodengruppen eines 3/6-Modenoszillators, wobei die Fig. 22 eine Motorvariante zeigt, die mit solchen Wandler oder Oszillatoren ausgerüstet ist. Ein derartiger Motor kann einen Wandler besitzen, der auf seiner unteren Oberfläche 9 zwei oder vier Friktionselemente 14 besitzt, so wie es die Fig. 19 mit der Position 85 zeigt. Bei der dargestellten Motorvariante besitzt der Wandler 6 drei fixierende Elemente 15, was seine mechanische Stabililtät verbessert.

Bei dem Antrieb oder Motor geschieht die Energieübertragung vom schwingenden Wandler 6 zum getriebenen Element 1 durch den Friktionskontakt zwischen dem Friktionselement 14 und der Friktionsschicht 2. Die Verwendung von zwei- oder dreischichtigen Friktionselementen 14 mit einer porösen Schicht 18 ermöglicht einen Ausgleich der Verschiedenheiten der elliptischen Bewegungsbahnen in Richtung der Friktionselementbreite hᵣ, wobei hier auf Fig. 23 hinzuweisen ist. Dies ist dadurch gegeben, daß die poröse Schicht deutlich die Querverformungskomponente des Friktionselements 14 verringert. Um eine hohe Homogenität und Gleichförmigkeit der Bewegungsbahnen in der Breite tr zu erhalten, werden vorteilhaft schmale Friktionselemente verwendet, die in der Fig. 23 mit den Positionen 87, 89 und 90 gezeigt sind.

Die Verwendung breiter Friktionselemente ermöglicht die Übertragung hoher Zugkräfte. Bei der Verwendung breiter Friktionselemente 14 muß beachtet werden, daß deren Breite tr fünfmal kleiner sein muß als eine Halbwellenlänge λ/2 der sich im Oszillator oder Wandler 6 ausbreitenden akustischen Biegewelle.

Um eine unerwünschte Erzeugung von akustischen Biegewellen im Körper des getriebenen Elements 1 zu vermeiden, soll die Stärke 1 vom Körper des getriebenen Elements 1 größer als eine Halbwellenlänge λt/2 der akustischen sich im plattenförmigen Wandler ausbreitenden Biegewelle sein. Um eine verbesserte akustische Isolation des getriebenen Elements 1 von der Friktionsschicht 2 zu gewährleisten, kann zwischen dem Körper des getriebenen Elements 1 und seiner Friktionsschicht 2 eine Dämpfungszwischenschicht 74 angeordnet werden, die aus einem schalldämmenden Werkstoff besteht. Eine solche Schicht ermöglicht es auch, die thermische Unverträglichkeit der Friktionsschicht 2 und des getriebenen Elements 1, die durch eine Verschiedenheit der Temperaturausdehnungskoeffizienten bedingt ist, zu beseitigen. Die Dämpfungsschicht 74 kann aus einem weichen organischen Werkstoff gefertigt sein, z.B. aus Polymerfilm bestehen oder aus einem porösen Material, z.B. porösem Aluminium gebildet werden. Auch ist eine Kombination aus einem harten Material mit einem weichen organischen Werkstoff denkbar.

Zur Erweiterung der Einsatzmöglichkeiten des Antriebs kann das getriebene Element als ein Balken mit einem rechteckigen, vieleckigen oder runden Querschnitt oder in Form eines Rohrs ausgebildet sein.

Bei der Ausführungsvariante des Motors mit mindestens drei piezoelektrischen Wandlern und mindestens drei Friktionsschichten 2, die zueinander parallel und mindestens in einer der Ebenen S1, S2 und S3 angeordnet sind, wie dies in Fig. 30 dargestellt wurde, ist das getriebene Element 1 in seiner zur Längsachse senkrecht stehenden Ebene mechanisch sehr stabil. Um eine Drehbewegung zu erhalten, kann das getriebene Element in Form eines Drehkörpers gefertigt und in Drehträger aufgestellt werden, wie die Fig. 17 und 18 erkennen lassen. Um die Positionierungsgenauigkeit zu erhöhen, besteht die Möglichkeit, die fixierenden Elemente des Wandlers 6 in starre Träger 100 aufzustellen, wie dies Fig. 30 darstellt. Hier wird der Wandler 6 absolut starr in der Längsrichtung bezüglich des Motorgehäuses 3 fixiert.

Zu den Wirkungsweisen der Ausführungsbeispiele der Schaltungsanordnungen zum Betreiben des Antriebs oder Motors ab Fig. 32 sei auf Nachstehendes aufmerksam gemacht.

Eine einfache Variante zur Erzeugung von akustischen Schwingungen zeigt Fig. 32, die mit einem Phasenschieber 101 ausgestattet ist. Dieser Phasenschieber dient einer Feinkorrektur der Phasenverschiebung zwischen den Spannungen Uf1 und Uf2. Eine solche Korrektur ist zur Optimierung der Bewegungsbahnen des Friktionselements 14 in bestimmten Fällen notwendig. Weiterhin besitzt der Grundgenerator 24 einen Eingang zur Ansteuerung der Erregerfrequenz. Der Steuereingang ermöglicht es, die Bewegungsgeschwindigkeit des getriebenen Elements zu verändern.

Bei der Schaltung nach Fig. 33 stellt der Grundgenerator 24 eine rechteckförmige Spannung Ug mit einer Frequenz bereit, die gleich der doppelten Resonanzfrequenz f10 der Längsschwingung des Wandlers ist. Diese Spannung wird an den Eingang 115 des Phasensteuerers 114 geführt und dort durch das Glied 124 in eine Sägezahnspannung umgeformt. Diese Sägezahnspannung gelangt an einen Pulsbreitenmodulator 124. An den Eingang 116 des Pulsweitenmodulators 124, der gleichzeitig auch der Steuerungseingang des Phasensteuerers ist, wird weiterhin die Steuerspannung Uϕ gegeben. Der Pulsmodulator 124 formt die Sägezahnspannung aus dem Glied 123 in eine rechteckige Spannung um, deren Impulsbreite proportional zu der an seinem Eingang 116 anliegenden Steuerspannung Uϕ ist. Diese Spannung gelangt auf die Formierglieder 125 und 126, die als Flip-Flop aufgebaut sind, und welche auf die Rück- und Vorderflanke der pulsweitenmodulierten Spannung reagieren.

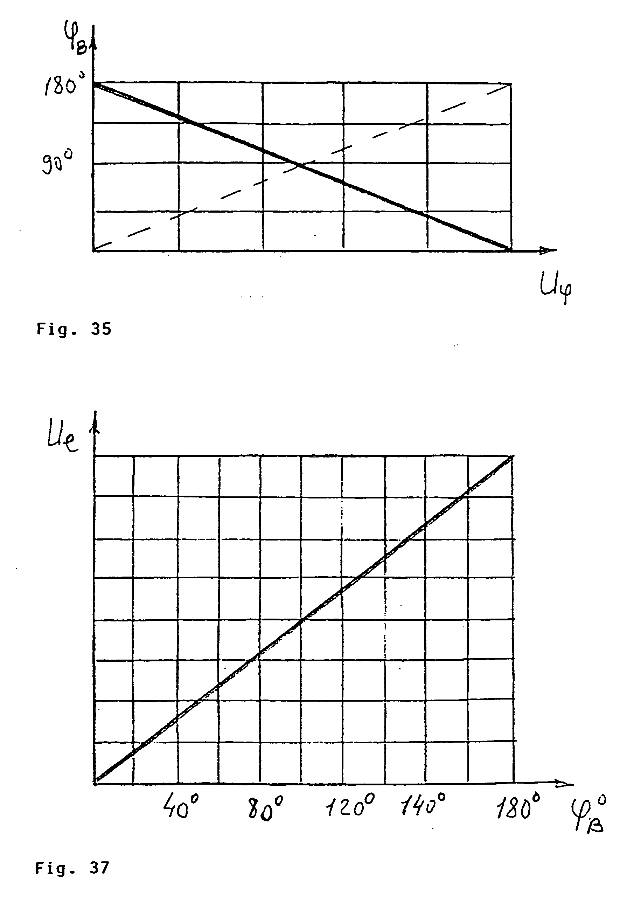

An den Ausgängen 117 und 118 des Phasensteuerers 114 resultieren somit symmetrische rechteckige Impulse. Deren Frequenz ist gleich der Frequenz f10 der Längsschwingungen des Wandlers und ihre Phasenverschiebung ϕb ist proportional zur Spannung Uϕ. Die Abhängigkeit der Phasenverschiebung ϕb von der Steuerspannung ist in der Fig. 35 gezeigt.

Die rechteckförmigen Spannungen von den Ausgängen 117 und 118 des Phasensteuerers 114 werden weiter an die Treiber 113 und danach an die Halbbrückenverstärker 105, 106 und 107, 108 geführt. An den Ausgängen 30, 33 und 31, 34 der Halbbrückenverstärker 105, 106 und 107, 108 entstehen rechteckige Spannungen Ub1 und Ub2. Deren Phasenverschiebung ϕb ist proportional zu der Steuerspannung Uϕ. Die Phasenverschiebung ϕb zwischen den Spannungen Ub1 und Ub2 bestimmt die Zeit, während der diese Spannungen auf die Belastung der Brückenverstärker 103 und 104 wirken und als solche die erste und die zweite Elektrodengruppe des Wandlers beaufschlagen.

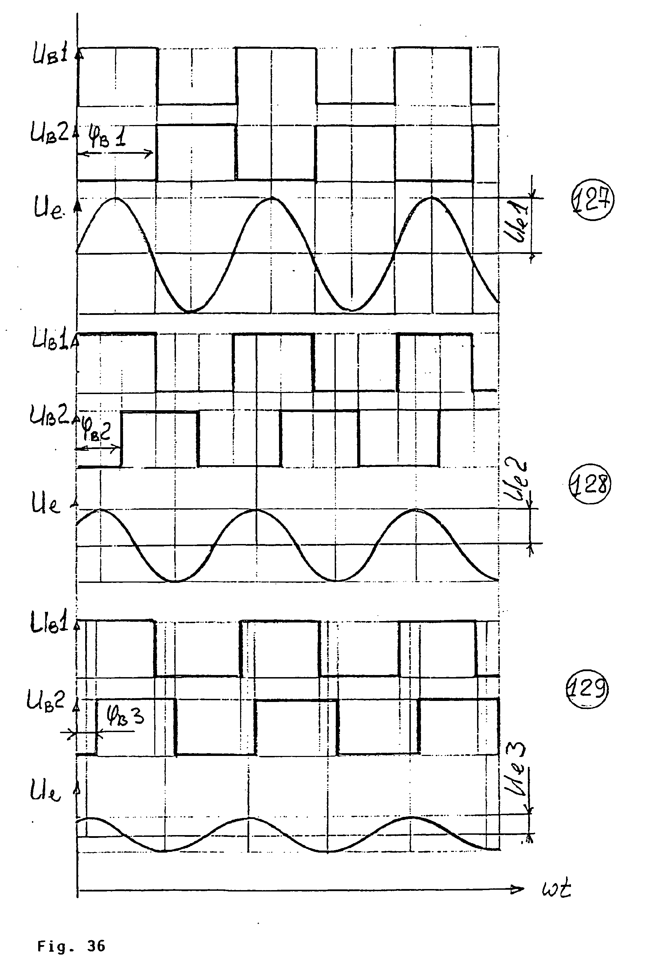

Die Spannungen Ub1 und Ub2 gelangen über die Filter 121 und 122 an die Anschlüsse 19, 20 und 21, 22 der ersten 12 und der zweiten 13 der Elektrodengruppen des Wandlers 6. Die Filter 121 und 122 lassen nur die erste Harmonische der durch diese Spannungen hervorgerufenen Schwingungen passieren. Zwischen den Anschlüssen 19, 20 und 21, 22 entstehen sinusförmige Spannungen Ue mit der Frequenz, die gleich der Resonanzfrequenz der f10 der Längsschwingungen des Wandlers ist, und mit einer Amplitude, die proportional der Phasenverschiebung ϕb ist. Fig. 36 zeigt Zeitdiagramme der Abhängigkeiten der Spannungsamplitude Ue von der Phasenverschiebung ϕb. Da die-Bewegungsgeschwindigkeit Vf des getriebenen Elements 1 proportional zu den Spannungen Ue ist, ergibt sich eine umgekehrte Proportionalität zu der Steuerspannung Uϕ, die am Eingang 116 des Phasensteuerers 114 anliegt.

Das Umschalten des elektronischen Schalters 119 verursacht eine um 180° erfolgende Phasenverschiebung zwischen den Spannungen an den Anschlüssen 19, 20 und 21, 22 der ersten 12 und der zweiten 13 Elektrodengruppe des Wandlers 6. Dies führt zu einer Richtungsänderung der Bewegung des getriebenen Elements.

Bei der Schaltung nach Fig. 39 wird die Steuerspannung Ur an den Eingang 131 des Signalpegelwandlers 130 und an den Eingang 134 des Nullsignaldetektors 133 angelegt. Der Wandler 130 hat eine doppelte Abhängigkeit zwischen der Spannung Uϕ an seinem Ausgang 132 und der Steuerspannung Ur an seinem Eingang 131. Diese Abhängigkeit ist in Fig. 40 mit Position 136 dargestellt. Auch mit Blick auf die Position 137 ist erkennbar, daß bei Durchgang der Spannung Ur halbwertseitig sich der Nullsignaldetektor 133 umschaltet, wie dies in Fig. 40, Position 138 deutlich gemacht wurde. Das Umschalten des Nullsignaldetektors führt zu einer Bewegungsänderung des getriebenen Elements in entgegengesetzte Richtung. Die resultierende Abhängigkeit der Bewegungsgeschwindigkeit Vf des getriebenen Elements 1 von der Steuerspannung Ur ist in der Fig. 40 mit Position 139 gezeigt. Die Nullgeschwindigkeit des getriebenen Elements 1 entspricht etwa der Hälfte der Steuerspannung Ur.

Bei der in Fig. 44 dargestellten Schaltungsvariante zum Betreiben des Motors wird die konstant bleibende Phasenverschiebung zur Frequenzstabilisierung des Motorarbeitspunkts genutzt. Hierfür stellt der Sensor der mechanischen Spannungskomponente 141 oder 148 eine sinusförmige elektrische Spannung bereit, die an die Anschlüsse 146 und 145 und weiter an den Formierer 161 geführt wird. Diese Spannung wird durch den Formierer 161 verstärkt und begrenzt, und zwar derart, daß eine rechteckige Verlaufsform entsteht. Die derart umgeformte Spannung gelangt an den Meßeingang 158 des Phasendetektors 156. An den Stützeingang 157 des Phasendetektors 156 wird die den Wandler 6 erregende Spannung, die durch den Formierer 160 signalgewandelt wurde, angelegt. Der Phasendetektor 156 stellt die Fehlerspannung bereit, die proportional der Abweichung der Phasenverschiebung zwischen den Spannungen an den Eingängen 157 und 158 ist. Diese Fehlerspannung gelangt vom Ausgang 159 des Phasendetektors 156 an den Eingang 102 zur elektrischen Ansteuerung der Trägerfrequenz des Grundgenerators 24.

Das System ist hierbei so eingestellt, daß beim Fehlen destabilisierender Werte die Fehlerspannung gleich Null ist und der Grundgenerator hier eine Frequenz erzeugt, die gleich der doppelten Resonanzfrequenz f10 der Längsschwingungen des Wandlers ist. Dabei ist die Phasenverschiebung gleich +90° oder gleich -90°.

Der Einfluß von destabilisierenden Faktoren führt zur Abweichung der Oszillatorresonanzfrequenz vom Anfangswert, wodurch die Phasenverschiebung geändert wird. Letzteres verursacht das Ausbilden einer Fehlerspannung am Ausgang 159 des Phasendetektors 156. Diese Fehlerspannung ändert die Frequenz des Grundgenerators derart, daß die Phasenverschiebung dann wieder 90° + oder - beträgt. Die Erregerfrequenz des Grundgenerators wird dann wieder gleich dem neuen Wert der doppelten Resonanzfrequenz von Längsschwingungen des Wandlers 6.

Das System hält also die Erregerfrequenz des Grundgenerators immer gleich der Resonanzfrequenz der Längsschwingungen des Wandlers 6. Damit ist die Schaltungsanordnung in der Lage, die Resonanzfrequenz des Oszillators auch bei mechanischen Belastungen oder Temperaturschwankungen konstant zu halten. Am Steuerungseingang 164 besteht die Möglichkeit, ein elektrisches Stabilisierungssystem zum Konstanthalten der Bewegungsgeschwindigkeit des getriebenen Elements anzuschließen.

Versuche mit einem erfindungsgemäßen Motor haben ergeben, daß mit einem 2/5-Modenoszillator mit Abmessungen von 60 x 6 x 3mm, enthaltend eine elektronische Anordnung zum Konstanthalten der Resonanzfrequenz des Oszillators, bei Bewegungsgeschwindigkeiten von 0.01 m/s die Ungleichförmigkeit der Geschwindigkeit des getriebenen Elements im Bereich von 5 bis maximal 10% liegt. Bei Geschwindigkeiten höher als 0,1 m/s liegt eine Ungleichförmigkeit in der Geschwindigkeitskonstanz im Bereich von 2%. Bei Einsatz eines elektronischen Stabilisierungssystems kann die Gleichförmigkeit bei einer Bewegungsgeschwindigkeit von 1 µm/s auf 2 bis 3% Abweichung gehalten werden. Eine solche Stabilität blieb über die gesamte Motorlaufzeit von ca. 10.000 Stunden erhalten. Die Ausführungsformen des vorgeschlagenen Antriebs sind bereits bei Erregungsspannungen im Bereich von 20 bis 150V betriebsfähig. Versuche mit einem Motor unter Verwendung eines 1/2-Modenoszillators vom Längstyp mit Abmessungen von 70 x 18,5 x 6 mm und zwei Friktionselementen führten zu erzeugten Kräften im Bereich von 52 N.

## Patentansprüche

1. Piezoelektrischer Antrieb, der ein mit einer Friktionsschicht versehenes getriebenes Element (1) und mindestens einen monolithischen plattenförmigen piezoelektrischen Wandler (6) als treibendes Element (5) enthält, dessen Länge ungleich seiner Breite ist, sowie mit ersten (12) und zweiten (13) Elektrodengruppen auf seinen großen Oberflächen (7) und mit mindestens einem, in elastischem Friktionskontakt mit der Friktionsschicht des getriebenen Elements (1) stehenden Friktionselement (14) an seinen kleineren Oberflächen, und weiterhin mit einem elektrischen Generator (23), der mit den obengenannten Elektrodengruppen (12,13) elektrisch verbindbar ist, wobei die erste und die zweite Elektrodengruppe (12,13) zwei Bereiche gleicher Konfiguration an den beiden großen gegenüberliegenden metallisierten Oberflächen (7) des plattenförmigen piezoelektrischen Wandlers darstellen und die erste Elektrodengruppe (12) ein Längswellengenerator (17) sowie die zweite (13) ein Biegewellengenerator (18) für akustische Wellen ist,
**dadurch gekennzeichnet, daß**
jede von beiden Elektrodengruppen (12,13) mindestens einen unabhängigen Wandler von nicht miteinander gekoppelten akustischen stehenden Wellen bilden, die sich längs der langen Seite des piezoelektrischen Wandlers (6) ausbreiten, einer senkrecht zu der ersten Elektrodengruppe (12) orientierten, dazwischen befindlichen einrichtungspolarisierten Piezokeramik, die sich an Orten von Schwingungsgeschwindigkeitsknoten der stehenden akustischen, sich im Wandler ausbreitenden Längswelle befindet sowie einer senkrecht zu der zweiten Elektrodengruppe (13) orientierten, dazwischen befindlichen einrichtungspolarisierten oder verschiedengerichteten, symmetrisch bezüglich der Längsachse des Wandlers polarisierten Piezokeramik, die sich an den Orten von Schwingungsgeschwindigkeitsmaxima der stehenden akustischen, sich im Wandler ausbreitenden Biegewelle befindet.

2. Piezoelektrischer Antrieb nach Anspruch 1,
**dadurch gekennzeichnet, daß**
die Friktionselemente (14) als dünne Streifen aus einem harten verschleißfesten Werkstoff ausgeführt sind und in Bereichen von Schwingungsgeschwindigkeitsmaxima der sich in dem plattenförmigen piezoelektrischen Wandler ausbreitenden akustischen Biegewelle angeordnet sind.

3. Piezoelektrischer Antrieb nach Anspruch 2,
**dadurch gekennzeichnet, daß**
die Friktionselemente (14) sich auf einer kleinen unteren Oberfläche des plattenförmigen piezoelektrischen Wandlers befinden.

4. Piezoelektrischer Antrieb nach einem der Ansprüche 1 bis 3,
**dadurch gekennzeichnet, daß**
ein Friktionselement (14) an einer der kleinen Seitenoberflächen (8) des plattenförmigen piezoelektrischen Wandlers (6) angeordnet ist.

5. Piezoelektrischer Antrieb nach einem der Ansprüche 1 bis 4,
**dadurch gekennzeichnet, daß**
die Friktionselemente (14) eine Zwei- oder Dreischichtstruktur besitzen, wobei die erste Schicht (87) dieser Struktur aus einem harten verschleißfesten, mit hoher Reibungszahl im Vergleich zu der Friktionsschicht des getriebenen Elements Stoff und die zweite Schicht (88) aus einem harten porösen Material besteht und beide Schichten durch Sintern miteinander verbunden sind, so daß im Verbindungsbereich der ersten und der zweiten Schicht eine dritte, dazwischen liegende Übergangsschicht entsteht.

6. Piezoelektrischer Antrieb nach einem der Ansprüche 1 bis 5,
**dadurch gekennzeichnet, daß**
die Friktionselemente (14) mittels eines Bindestoffs mit der Oberfläche des plattenförmigen piezoelektrischen Wandlers (6) verbunden sind, der sowohl mit der piezoelektrischen Keramik als auch mit dem Material des Friktionselements (14) eine chemische Verbindung eingeht.

7. Piezoelektrischer Antrieb nach einem der Ansprüche 1 bis 6,
**dadurch gekennzeichnet, daß**
Friktionselemente (14) als Glasstreifen ausgebildet sind, die auf die Oberfläche (10,11) des plattenförmigen piezoelektrischen Wandlers aufgeschmolzen sind, wobei das Glas einen Pulverzusatz eines harten verschleißfesten Werkstoffs aufweist.

8. Piezoelektrischer Antrieb nach einem der vorangegangenen Ansprüche,
**dadurch gekennzeichnet, daß**
der monolithische plattenförmige piezoelektrische Wandler (6) mit mindestens einem, fest mit diesem verbundenen fixierenden Element (15) ausgestattet ist.

9. Piezoelektrischer Antrieb nach Anspruch 8,
**dadurch gekennzeichnet, daß**
die fixierenden Elemente (15) als rechteckige (89), dreieckige (90), halbzylindrische Prismen (91) oder als konische (92), pyramidenförmige (93), halbsphärische (94) Elemente mit Profilbohrungen (97,98) ausgeführt sind und diese an Orten von Schwingungsknoten der stehenden akustischen, sich in dem Wandler (6) ausbildenden Längswelle und starr mit der Piezokeramikoberfläche verbunden angeordnet sind.

10. Piezoelektrischer Antrieb nach Anspruch 9,
**dadurch gekennzeichnet, daß**
die fixierenden Elemente (15) aus einem Werkstoff bestehen, dessen Elastizitätsmodul ungefähr gleich oder geringfügig höher als derjenige der Piezokeramik ist.

11. Piezoelektrischer Antrieb nach Anspruch 9,
**dadurch gekennzeichnet, daß**
die fixierenden Elemente (15) aus einem Werkstoff bestehen, dessen Elastizitätsmodul viel kleiner ist als der Elastizitätsmodul der Piezokeramik des plattenförmigen piezoelektrischen Wandlers (6).

12. Piezoelektrischer Antrieb nach Anspruch 9,
**dadurch gekennzeichnet, daß**
die fixierenden Elemente (15) und der plattenförmige piezoelektrische Wandler (6) aus demselben Piezokeramiktyp bestehen.

13. Piezoelektrischer Antrieb nach einem der vorangegangenen Ansprüche,
**dadurch gekennzeichnet, daß**
jedes fixierende Element (15) oder ein Teil desselben aus poröser Oxidkeramik oder einem anderen porösen Werkstoff besteht.

14. Piezoelektrischer Antrieb nach Anspruch 1,
**dadurch gekennzeichnet, daß**
die fixierenden Elemente (15) als biegende Resonanzplatten (76) ausgeführt sind.

15. Piezoelektrischer Antrieb nach einem der vorangegangenen Ansprüche,
**dadurch gekennzeichnet, daß**
die fixierenden Elemente (15) mit Hilfe organischer Kleber mit der Piezokeramikoberfläche verbunden sind.

16. Piezoelektrischer Antrieb nach einem der Ansprüche 1 bis 14,
**dadurch gekennzeichnet, daß**
die fixierenden Elemente (15) mittels eines Werkstoffs mit der Piezokeramikoberfläche verbunden sind, welcher eine chemische Verbindung mit der Piezokeramik und dem Material des fixierenden Elements (15) eingeht.

17. Piezoelektrischer Antrieb nach Anspruch 1,
**dadurch gekennzeichnet, daß**
die Friktionsschicht (2) des getriebenen Elements (1) eine Keramikoxidschicht ist mit der Dicke mindestens fünfmal kleiner als eine Halbwellenlänge (λ/2) der sich im Wandler (6) ausbreitenden akustischen stehenden Längswelle.

18. Piezoelektrischer Antrieb nach Anspruch 1 oder 17,
**dadurch gekennzeichnet, daß**
die Körperdicke des unter der Friktionsschicht (2) befindlichen getriebenen Elements (1) größer als eine Halbwellenlänge (λ/2) der sich im Wandler ausbreitenden akustischen stehenden Biegewelle ist.

19. Piezoelektrischer Antrieb nach Anspruch 1, 17 oder 18,
**dadurch gekennzeichnet, daß**
zwischen dem Körper des getriebenen Elements (1) und seiner Friktionsschicht (2) eine Dämpfungsschicht (74) angeordnet ist.

20. Piezoelektrischer Antrieb nach Anspruch 1,
**dadurch gekennzeichnet, daß**
das getriebene Element (1) die Form eines rechteckigen, vieleckigen oder runden Querschnitt aufweisenden Balkens (93-95) besitzt.

21. Piezoelektrischer Antrieb nach Anspruch 1,
**dadurch gekennzeichnet, daß**
das getriebene Element (1) die Form eines Rohrs (96) besitzt.

22. Piezoelektrischer Antrieb nach Anspruch 1,
**dadurch gekennzeichnet, daß**
das getriebene Element (1) ein Balken aus hartem Material mit rechteckigem Querschnitt ist, dessen Balkenkörper periodische Dämpfungsnuten (99) aufweist.

23. Piezoelektrischer Antrieb nach Anspruch 1,
**dadurch gekennzeichnet, daß**
das getriebene Element (1) aus einem harten porösen Werkstoff besteht.

24. Piezoelektrischer Antrieb nach Anspruch 23,
**dadurch gekennzeichnet, daß**
die Poren des getriebenen Elements (1) mit einem schalldämpfenden Stoff aufgefüllt sind.

25. Piezoelektrischer Antrieb nach einem der vorangegangenen Ansprüche,
**dadurch gekennzeichnet, daß**
mindestens zwei gegenüberstehende und in einer Ebene liegende plattenförmige piezoelektrische Wandler (6) mit mindestens zwei Friktionsschichten (2) vorgesehen sind und die Wandler parallel zueinander stehen und sich an zwei gegenüberliegenden Seiten des getriebenen Elements (1) befinden.

26. Piezoelektrischer Antrieb nach einem der vorangegangenen Ansprüche,
**dadurch gekennzeichnet, daß**
mindestens drei plattenförmige piezoelektrische Wandler (6) mit mindestens drei Friktionsschichten (2) vorgesehen sind, die parallel zueinander stehen und mindestens in drei Ebenen liegen.

27. Piezoelektrischer Antrieb nach Anspruch 1,
**dadurch gekennzeichnet, daß**
das getriebene Element (1) als Rotationskörper ausgeführt und in einem Rotationsträger aufgestellt ist.

28. Piezoelektrischer Antrieb nach einem der vorangegangenen Ansprüche,
**dadurch gekennzeichnet, daß**
die fixierenden Elemente (15) des plattenförmigen piezoelektrischen Wandlers (6) in festen Trägern befindlich sind.

29. Piezoelektrischer Antrieb nach einem der Ansprüche 1 bis 27,
**dadurch gekennzeichnet, daß**
die fixierenden Elemente (15) des plattenförmigen piezoelektrischen Wandlers (6) in flachen federartigen Trägern befestigt sind.

## Claims

1. A piezoelectric drive which comprises a driven element (1) provided with a friction layer and at least one monolithic plate-shaped piezoelectric transducer (6) as the driving element (5), whose length is not equal to its width, as well as with first (12) and second (13) electrode groups on its large surfaces (7) and with at least one friction element (14) on its smaller surfaces being in elastic friction contact with the friction layer of the driven element (1), and further with an electric generator (23) which is electrically connectable with the above mentioned electrode groups (12, 13), with the first and second electrode group (12, 13) representing two areas of identical configuration on the two large opposite metallized surfaces (7) of the plate-shaped piezoelectric transducer, and the first electrode group (12) being a longitudinal wave generator (17) and the second one (13) being a flexural wave generator (18) for acoustic waves,
**characterized in that**
each of the two electrode groups (12, 13) forms at least one independent transducer of acoustic standing waves not coupled to each other which propagate along the long side of the piezoelectric transducer (6), from a unidirectionally polarised piezoelectric ceramic oriented perpendicular to the first electrode group (12) and arranged between them, which is located in sites of oscillation velocity nodes of the standing acoustic longitudinal wave propagating in the transducer, and from a piezoelectric ceramic which is oriented perpendicular to the second electrode group (13) and arranged between them and is unidirectionally polarised or heterodirectionally symmetrically polarised with respect to the longitudinal axis of the transducer, which is disposed in the sites of oscillation velocity maxima of the standing acoustic flexural wave propagating in the transducer.

2. The piezoelectric drive according to Claim 1,
**characterized in that**
the friction elements (14) are designed as thin strips of a hard, wear-resistant material and arranged in areas of oscillation velocity maxima of the acoustic flexural wave propagating in the plate-shaped piezoelectric transducer.

3. The piezoelectric drive according to Claim 2,
**characterized in that**
the friction elements (14) are disposed on a small lower surface of the plate-shaped piezoelectric transducer.

4. The piezoelectric drive according to one of Claims 1 to 3,
**characterized in that**
one friction element (14) is arranged on one of the small lateral surfaces (8) of the plate-shaped piezoelectric transducer (6).

5. The piezoelectric drive according to one of Claims 1 to 4,
**characterized in that**
the friction elements (14) have a two- or three-layer structure, with the first layer (87) of this structure consisting of a hard, wear-resistant substance with a high friction factor compared to the friction layer of the driven element, and the second layer (88) consisting of a hard, porous material, and that both layers are bonded with each other by sintering so that in the interface area of the first and the second layer a third transition layer is generated in between.

6. The piezoelectric drive according to one of Claims 1 to 5,
**characterized in that**
the friction elements (14) are bonded with the surface of the plate-shaped piezoelectric transducer (6) by means of a bonding agent which chemically reacts both with the piezoelectric ceramic and the material of the friction element (14).

7. The piezoelectric drive according to one of Claims 1 to 6,
**characterized in that**
the friction elements (14) are formed as glass strips which are fused onto the surface (10, 11) of the plate-shaped piezoelectric transducer, with the glass comprising a powder additive of a hard, wear-resistant material.

8. The piezoelectric drive according to one of the previous claims,
**characterized in that**
the monolithic plate-shaped piezoelectric transducer (6) is equipped with at least one fixing element (15) securely joined with same.

9. The piezoelectric drive according to Claim 8,
**characterized in that**
the fixing elements (15) are designed as rectangular (89), triangular (90), semi-cylindrical prisms (91) or as conical (92), pyramid-shaped (93), semi-spherical (94) elements with profile holes (97, 98) and arranged in sites of oscillation nodes of the standing acoustic longitudinal wave propagating in the transducer (6) and are rigidly joined with the piezoelectric ceramic surface.

10. The piezoelectric drive according to Claim 9,
**characterized in that**
the fixing elements (15) consist of a material whose modulus of elasticity is approximately equal to or slightly higher than that of the piezoelectric ceramic.

11. The piezoelectric drive according to Claim 9,
**characterized in that**
the fixing elements (15) consist of a material whose modulus of elasticity is much smaller than the modulus of elasticity of the piezoelectric ceramic of the plate-shaped piezoelectric transducer (6).

12. The piezoelectric drive according to Claim 9,
**characterized in that**
the fixing elements (15) and the plate-shaped piezoelectric transducer (6) consist of the same type of piezoelectric ceramic.

13. The piezoelectric drive according to one of the previous claims,
**characterized in that**
each fixing element (15) or a part of same consists of porous oxide ceramic or of another porous material.

14. The piezoelectric drive according to Claim 1,
**characterized in that**
the fixing elements (15) are designed as bending resonance plates (76).

15. The piezoelectric drive according to one of the previous claims,
**characterized in that**
the fixing elements (15) are joined with the piezoelectric ceramic surface by means of organic adhesives.

16. The piezoelectric drive according to one of Claims 1 to 14,
**characterized in that**
the fixing elements (15) are joined with the piezoelectric ceramic surface by means of a material which chemically
reacts with the piezoelectric ceramic and the material of the fixing element (15).

17. The piezoelectric drive according to Claim 1,
**characterized in that**
the friction layer (2) of the driven element (1) is a ceramic oxide layer with a thickness at least five times smaller than a half-wave length (λ/2) of the acoustic standing longitudinal wave propagating in the transducer (6).

18. The piezoelectric drive according to Claim 1 or 17,
**characterized in that**
the body thickness of the driven element (1) located below the friction layer (2) is greater than a half-wave length (λ/2) of the acoustic standing flexural wave propagating in the transducer.

19. The piezoelectric drive according to Claim 1, 17 or 18,
**characterized in that**
a damping layer (74) is arranged between the body of the driven element (1) and its friction layer (2).

20. The piezoelectric drive according to Claim 1,
**characterized in that**
the driven element (1) has the shape of a bar (93-95) comprising a rectangular, polygonal, or round cross-section.

21. The piezoelectric drive according to Claim 1,
**characterized in that**
the driven element (1) has the shape of a tube (96).

22. The piezoelectric drive according to Claim 1,
**characterized in that**
the driven element (1) is a bar of hard material with a rectangular cross-section, whose bar body comprises periodic damping grooves (99).

23. The piezoelectric drive according to Claim 1,
**characterized in that**
the driven element (1) consists of a hard, porous material.

24. The piezoelectric drive according to Claim 23,
**characterized in that**
the pores of the driven element (1) are filled up with a sound-absorbing substance.

25. The piezoelectric drive according to one of the previous claims,
**characterized in that**
at least two plate-shaped piezoelectric transducers (6) arranged opposite each other and lying in one plane are provided with at least two friction layers (2) and the transducers are parallel to each other and are disposed on two opposite sides of the driven element (1).

26. The piezoelectric drive according to one of the previous claims,
**characterized in that**
at least three plate-shaped piezoelectric transducers (6) with at least three friction layers (2) are provided which are parallel to each other and lie in at least three planes.

27. The piezoelectric drive according to Claim 1,
**characterized in that**
the driven element (1) is designed as a rotating body and placed in a rotating girder.

28. The piezoelectric drive according to one of the previous claims,
**characterized in that**
the fixing elements (15) of the plate-shaped piezoelectric transducer (6) are located in stationary girders.

29. The piezoelectric drive according to one of Claims 1 to 27,
**characterized in that**
the fixing elements (15) of the plate-shaped piezoelectric transducer (6) are fastened in flat spring-type carriers.

## Revendications

1. Entraînement piézo-électrique, qui contient un élément entraîné (1) doté d'une couche de friction et au moins un convertisseur piézo-électrique monolithique (6) en forme de plaque à titre d'élément entraîneur (5), dont la longueur est différente de sa largeur, ainsi que des premiers (12) et des deuxièmes (13) groupes d'électrodes sur ses grandes surfaces (7) et au moins un élément de friction (14) qui se trouve en contact en friction élastique avec la couche de friction de l'élément entraîné (1), sur ses petites surfaces, et comprenant en outre un générateur électrique (23) susceptible d'être raccordé électriquement aux groupes d'électrodes (12, 13) mentionnés ci-dessus, dans lequel le premier et le deuxième groupe d'électrodes (12, 13) représentent deux zones de même configuration sur les deux grandes surfaces (7) métallisées opposées du convertisseur piézo-électrique en forme de plaque, et le premier groupe d'électrodes (12) est un générateur d'ondes longitudinales (17) et le deuxième groupe d'électrodes (13) est un générateur d'ondes de flexion (18) pour des ondes acoustiques,
**caractérisé en ce que**
chacun des deux groupes d'électrodes (12, 13) forme au moins un convertisseur indépendant d'ondes stationnaires acoustiques qui ne sont pas couplées les unes aux autres et qui se propagent le long du grand côté du convertisseur piézo-électrique (6), provenant d'une piézo-céramique à polarisation mono-directionnelle, orientée perpendiculairement au premier groupe d'électrodes (12) et située entre celles-ci, ladite piézo-céramique se trouvant aux emplacements des noeuds de vitesse d'oscillation de l'onde acoustique longitudinale stationnaire qui se propage dans le convertisseur, et provenant d'une piézo-céramique à polarisation mono-directionnelle orientée perpendiculairement au second groupe d'électrodes (13) et située entre celles-ci, ou d'une piézo-céramique polarisée dans différentes directions et symétrique par rapport à l'axe longitudinal du convertisseur, ladite piézo-céramique se trouvant aux emplacements des maxima de vitesse d'oscillation de l'onde acoustique stationnaire de flexion qui se propage dans le convertisseur.

2. Entraînement piézo-électrique selon la revendication 1,
**caractérisé en ce que** les éléments de friction (14) sont réalisés sous forme de bandes minces en un matériau dur résistant à l'usure et sont agencés dans les zones des maxima des vitesses d'oscillation de l'onde de flexion acoustique qui se propage dans le convertisseur piézo-électrique en forme de plaque.

3. Entraînement piézo-électrique selon la revendication 2,
**caractérisé en ce que** les éléments de friction (14) se trouvent sur une petite surface inférieure du convertisseur piézo-électrique en forme de plaque.

4. Entraînement piézo-électrique selon l'une des revendications 1 à 3,
**caractérisé en ce qu'**un élément de friction (14) est agencé sur l'une des petites surfaces latérales (8) du convertisseur piézo-électrique en forme de plaque (6).

5. Entraînement piézo-électrique selon l'une des revendications 1 à 4,
**caractérisé en ce que** les éléments de friction (14) possèdent une structure à deux couches ou à trois couches, dans laquelle la première couche (87) de cette structure est en un matériau dur résistant à l'usure présentant un coefficient de friction élevé par comparaison à la couche de friction de l'élément entraîné, et la seconde couche (88) est en un matériau dur poreux, et les deux couches sont reliées l'une à l'autre par frittage de sorte que dans la zone de liaison de la première et de la deuxième couche apparaît une troisième couche de transition située entre elles.

6. Entraînement piézo-électrique selon l'une des revendications 1 à 5,
**caractérisé en ce que** les éléments de friction (14) sont reliés au moyen d'un liant à la surface du convertisseur piézo-électrique en forme de plaque (6), ce liant établissant une liaison chimique aussi bien avec la céramique piézo-électrique qu'avec le matériau de l'élément de friction (14).

7. Entraînement piézo-électrique selon l'une des revendications 1 à 6,
**caractérisé en ce que** les éléments de friction (14) sont réalisés sous forme de bandes de verre, qui sont appliquées par fusion sur la surface (10, 11) du convertisseur piézo-électrique en forme de plaque, ledit verre comprenant un additif en poudre d'un matériau dur résistant à l'usure.

8. Entraînement piézo-électrique selon l'une des revendications précédentes,
**caractérisé en ce que** le convertisseur piézo-électrique monolithique en forme de plaque (6) est équipé d'au moins un élément de fixation (15) fermement relié à celui-ci.

9. Entraînement piézo-électrique selon la revendication 8,
**caractérisé en ce que** les éléments de fixation (15) sont réalisés sous forme de prismes rectangulaires (89), triangulaires (90), demi-cylindriques (91), ou sous forme d'éléments coniques (92), pyramidaux (93), ou demi-sphériques (94) avec des perçages profilés (97, 98), et **en ce qu'**ils sont agencés aux emplacements des noeuds d'oscillation des ondes acoustiques longitudinales stationnaires qui se forment dans le convertisseur (6) et sont reliés de façon rigide à la surface de l'élément piézo-céramique.

10. Entraînement piézo-électrique selon la revendication 9,
**caractérisé en ce que** les éléments de fixation (15) sont en un matériau dont le module d'élasticité est approximativement égal ou légèrement supérieur à celui de la piézo-céramique.

11. Entraînement piézo-électrique selon la revendication 9,
**caractérisé en ce que** les éléments de fixation (15) sont en un matériau dont le module d'élasticité est beaucoup plus petit que le module d'élasticité de la piézo-céramique du convertisseur piézo-électrique en forme de plaque (6).

12. Entraînement piézo-électrique selon la revendication 9,
**caractérisé en ce que** les éléments de fixation (15) et le convertisseur piézo-électrique en forme de plaque (6) sont réalisés à partir du même type de piézo-céramique.

13. Entraînement piézo-électrique selon l'une des revendications précédentes,
**caractérisé en ce que** chaque élément de fixation (15), ou une partie de celui-ci, est réalisé en céramique oxyde poreuse ou en un autre matériau poreux.

14. Entraînement piézo-électrique selon la revendication 1,
**caractérisé en ce que** les éléments de fixation (15) sont réalisés sous forme de plaques de résonance en flexion (76).

15. Entraînement piézo-électrique selon l'une des revendications précédentes,
**caractérisé en ce que** les éléments de fixation (15) sont reliés à la surface de la piézo-céramique à l'aide de colle organique.

16. Entraînement piézo-électrique selon l'une des revendications 1 à 14,
**caractérisé en ce que** les éléments de fixation (15) sont reliés à la surface de la piézo-céramique avec un matériau qui établit une liaison chimique avec la piézo-céramique et avec le matériau de l'élément de fixation (15).

17. Entraînement piézo-électrique selon la revendication 1,
**caractérisé en ce que** la couche de friction (2) de l'élément entraîné (1) est une couche de céramique oxyde avec une épaisseur au moins cinq fois plus petite qu'une demi-longueur d'onde (λ/2) de l'onde longitudinale acoustique stationnaire qui se propage dans le convertisseur (6).

18. Entraînement piézo-électrique selon la revendication 1 ou 17,
**caractérisé en ce que** l'épaisseur corporelle de l'élément entraîné (1) qui se trouve au-dessous de la couche de friction (2) est supérieure à une demi-longueur d'onde (λ/2) de l'onde de flexion acoustique stationnaire qui se propage dans le convertisseur.

19. Entraînement piézo-électrique selon la revendication 1, 17 ou 18,
**caractérisé en ce qu'**une couche d'amortissement (74) est agencée entre le corps de l'élément entraîné (1) et sa couche de friction (2).

20. Entraînement piézo-électrique selon la revendication 1,
**caractérisé en ce que** l'élément entraîné (1) possède la forme d'un barreau (93-95) présentant une section rectangulaire, polygonale ou ronde.

21. Entraînement piézo-électrique selon la revendication 1,
**caractérisé en ce que** l'élément entraîné (1) possède la forme d'un tube (96).

22. Entraînement piézo-électrique selon la revendication 1,
**caractérisé en ce que** l'élément entraîné (1) est un barreau en matériau dur à section rectangulaire, dont le corps présente des gorges d'amortissement périodiques (99).

23. Entraînement piézo-électrique selon la revendication 1,
**caractérisé en ce que** l'élément entraîné (1) est en un matériau dur poreux.

24. Entraînement piézo-électrique selon la revendication 23,
**caractérisé en ce que** les pores de l'élément entraîné (1) sont remplis d'un matériau d'amortissement acoustique.

25. Entraînement piézo-électrique selon l'une des revendications précédentes,
**caractérisé en ce qu'**il est prévu au moins deux convertisseurs piézo-électriques en forme de plaque (6), mutuellement opposés et situés dans un plan, avec au moins deux couches de friction (2), et **en ce que** lesdits convertisseurs sont disposés parallèlement l'un à l'autre et se trouvent sur deux côtés opposés de l'élément entraîné (1).

26. Entraînement piézo-électrique selon l'une des revendications précédentes,
**caractérisé en ce qu'**il est prévu au moins trois convertisseurs piézo-électriques en forme de plaque (6) avec au moins trois couches de friction (2) qui sont disposées parallèlement les unes aux autres et sont situées dans au moins trois plans.

27. Entraînement piézo-électrique selon la revendication 1,
**caractérisé en ce que** l'élément entraîné (1) est réalisé sous forme de corps rotatif et est installé dans un support rotatif.

28. Entraînement piézo-électrique selon l'une des revendications précédentes,
**caractérisé en ce que** les éléments de fixation (15) du convertisseur piézo-électrique en forme de plaque (6) se trouvent dans des supports fixes.

29. Entraînement piézo-électrique selon l'une des revendications 1 à 27,
**caractérisé en ce que** les éléments de fixation (15) du convertisseur piézo-électrique en forme de plaque (6) sont fixés dans des supports plats analogues à des ressorts.
